(19) Europäisches Patentamt
European Patent Office
Office européen des brevets

(11) EP 2 588 563 B1

(12) **EUROPÄISCHE PATENTSCHRIFT**

(45) Veröffentlichungstag und Bekanntmachung des Hinweises auf die Patenterteilung:
**25.03.2015 Patentblatt 2015/13**

(21) Anmeldenummer: **11741137.1**

(22) Anmeldetag: **28.06.2011**

(51) Int Cl.:
***C09K 11/06*** *(2006.01)* ***H05B 33/14*** *(2006.01)*
***H01L 51/00*** *(2006.01)* ***H01L 51/50*** *(2006.01)*

(86) Internationale Anmeldenummer:
**PCT/EP2011/060834**

(87) Internationale Veröffentlichungsnummer:
**WO 2012/001002 (05.01.2012 Gazette 2012/01)**

(54) **SINGULETT-HARVESTING MIT ORGANISCHEN MOLEKÜLEN FÜR OPTO-ELEKTRONISCHE VORRICHTUNGEN**

SINGLET HARVESTING WITH ORGANIC MOLECULES FOR OPTOELECTRONIC DEVICES

RÉCOLTE DE SINGULETS AU MOYEN DE MOLÉCULES ORGANIQUES POUR DES DISPOSITIFS OPTO-ÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.06.2010 DE 102010025547**

(43) Veröffentlichungstag der Anmeldung:
**08.05.2013 Patentblatt 2013/19**

(73) Patentinhaber: **cynora GmbH**
**76646 Bruchsal (DE)**

(72) Erfinder: **YERSIN, Hartmut**
**93161 Sinzing (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**WO-A1-2011/089163**
**DE-A1-102007 031 261**
**DE-A1-102008 033 563**
**US-A1- 2002 008 233**
**US-A1- 2005 214 576**
**US-B1- 6 420 056**
**US-B1- 7 416 791**

- **HARTMUT YERSIN: "Organometallic triplet emitters for OLED applications: controlling emission properties by chemical variation", PROCEEDINGS OF SPIE, Bd. 5214, 2004, Seiten 124-132, XP55015222, ISSN: 0277-786X, DOI: 10.1117/12.510009**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft die Verwendung von organischen Farbstoffen als Emitter in OLEDs (organic light emitting diodes) und in anderen opto-elektronischen Anordnungen.

## Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Besonders interessant ist auch, dass Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein werden. Die Bildschirme werden sich als Mikro-Displays oder Großbildschirme mit mehreren Quadratmetern Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der OLEDs, den Organic Light Emitting Diodes. Darüber hinaus zeichnen sich durch die Verwendung spezieller organischer Materialien (Moleküle) viele neue opto-elektronische Anwendungen, z. B. im Bereich organischer Solarzellen, organischer Feldeffekttransistoren, organischer Photodioden usw. ab.

Besonders für den OLED-Bereich lässt sich erkennen, dass derartige Anordnungen bereits jetzt wirtschaftlich bedeutend sind, da eine Massenfertigung in Kürze zu erwarten ist. Derartige OLEDs bestehen vorwiegend aus organischen Schichten, die auch flexibel und kostengünstig zu fertigen sind. OLED-Bauelemente lassen sich großflächig als Beleuchtungskörper, aber auch klein als Pixels für Displays gestalten.

Gegenüber herkömmlichen Technologien, wie etwa Flüssigkristall-Displays (LCDs), Plasma-Displays oder Kathodenstrahlenröhren (CRTs), weisen OLEDs zahlreiche Vorteile auf, wie eine geringe Betriebsspannung von einigen Volt, eine dünne Struktur von nur einigen hundert nm, hoch-effizient selbst-leuchtende Pixel, einen hohen Kontrast und eine gute Auflösung sowie die Möglichkeit, alle Farben darzustellen. Weiterhin wird in einem OLED Licht beim Anliegen elektrischer Spannung direkt erzeugt anstelle es nur zu modulieren.

Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten über OLEDs (siehe z.B. Tang et al., Appl. Phys. Lett. 1987, 51, 913) sind diese Vorrichtungen besonders im Hinblick auf die eingesetzten Emittermaterialien weiterentwickelt worden, wobei insbesondere in den letzten Jahren sogenannte Triplett- oder auch andere phosphoreszierende Emitter von Interesse sind.

OLEDs werden in der Regel in Schichtenstrukturen realisiert. Zum besseren Verständnis ist in Fig. 1 ein prinzipieller Aufbau eines OLEDs gezeigt. Aufgrund der angelegten äußeren Spannung an einer transparenten Indium-Zinn-Oxid-Anode (ITO) und einer dünnen Metall-Kathode werden von der Anode positive Löcher und von der Kathode negative Elektronen injiziert. Diese verschieden geladenen Ladungsträger gelangen über Zwischenschichten, die auch aus hier nicht gezeichneten Loch- bzw. Elektronen-Blockierschichten bestehen können, in die Emissionsschicht. Dort treffen die entgegengesetzt geladenen Ladungsträger an oder in der Nähe von dotierten Emitter-Molekülen zusammen und rekombinieren. Die Emitter-Moleküle sind in der Regel in Matrizen bestehend aus kleinen Molekülen oder Polymermatrizen (in z. B. 2 bis 10 Gew.-%) eingelagert, wobei die Matrix-Materialien so gewählt sind, dass sie auch einen Loch- und Elektronentransport ermöglichen. Durch die Rekombination entstehen Exzitonen (= Anregungszustände), die ihre Überschussenergie auf die jeweilige elektro-lumineszierende Verbindung übertragen. Diese Verbindung kann daraufhin in einen bestimmten elektronischen Anregungszustand übergehen, der dann möglichst vollständig und unter weitgehender Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder Triplett-Zustand in Betracht. Da beide Zustände aufgrund der Spinstatistik in der Regel im Verhältnis 1:3 besetzt werden, ergibt sich, dass bei einer Emission aus dem Singulett-Zustand, die als Fluoreszenz bezeichnet wird, nach dem Stand der bisherigen Technik, nur maximal 25 % der erzeugten Exzitonen zur Emission führen. Dagegen können bei einer Triplett-Emission, die als Phosphoreszenz bezeichnet wird, sämtliche Exzitonen ausgenutzt, umgewandelt und als Licht emittiert werden (Triplett-Harvesting), so dass in diesem Fall die Innere Quantenausbeute den Wert von 100 % erreichen kann, sofern der mitangeregte und energetisch über dem Triplett-Zustand liegende Singulett-Zustand vollständig in den Triplett-Zustand relaxiert (Inter-System-Crossing, ISC) und strahlungslose Konkurrenzprozesse bedeutungslos bleiben. Somit sind Triplett-Emitter nach dem bisherigen Stand der Technik effizientere Elektro-Luminophore und besser geeignet als rein organische Singulett-Emitter, in einer organischen Leuchtdiode für eine hohe Lichtausbeute zu sorgen.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422)

Die bisher bekannten phosphoreszierenden, metall-organischen Triplett-Emitter in OLEDs weisen allerdings einen Nachteil auf, der darin besteht, dass die Emissionslebensdauer, die im Bereich von mehreren Mikrosekunden liegt, relativ lang ist. Dadurch ergeben sich mit wachsenden Stromdichten und die dadurch resultierende Besetzung eines Großteils oder aller Emittermoleküle Sättigungseffekte. In der Folge können weitere Ladungsträger-Ströme nicht mehr vollständig zur Besetzung der angeregten und emittierenden Zustände führen. Es resultieren dann nur unerwünschte ohmsche Verluste. Infolgedessen ergibt sich mit steigender Stromdichte ein deutlicher Effizienz-Abfall des OLED-Devices (sog. "Roll-Off" Verhalten). In ähnlich ungünstiger Weise wirken sich die Effekte der Triplett-Triplett-Annihilation und des Self-Quenchens aus (siehe dazu z.B. H. Yersin, "Highly Efficient Annihilation und des Self-Quenchens aus (siehe dazu z.B. H. Yersin, "Highly Efficient OLEDs with Phosphorescent Materials", Wiley-VCH, Weinheim 2008 und S. R. Forrest et al., Phys. Rev. B 2008, 77, 235215). So zeigen sich insbesondere Nachteile bei der Verwendung von Emittern mit langen Emissionslebensdauern für OLED-Beleuchtungen, bei denen eine hohe Leuchtdichte, z. B. von über 1000 $cd/m^2$ gefordert wird (vergleiche: J. Kido et al. Jap. J. Appl. Phys. 2007, 46, L10.). Darüber hinaus sind Moleküle in elektronisch angeregten Zuständen in der Regel chemisch reaktiver als Moleküle in Grundzuständen, so dass die Wahrscheinlichkeit unerwünschter chemischer Reaktionen mit der Länge der Emissionslebensdauer wächst. Infolgedessen wird angestrebt, Emitter-Moleküle mit möglichst kurzer Emissionslebensdauer, aber dennoch hoher Emissionsquantenausbeute zu entwickeln. OLEDs unter Verwendung derartiger Emitter zeigen dann ein deutlich geringeres Roll-Off-Verhalten der Effizienz und ermöglichen darüber hinaus eine längere Lebensdauer der optoelektronischen Vorrichtung.

Zusammenfassend lässt sich der Stand der Technik so beschreiben, dass die bisher bekannten an sich effiziente Triplett-Emitter die Nachteile aufweisen, dass

- teure Edelmetall-Moleküle verwendet werden müssen und dass
- die unter Verwendung derartiger Moleküle erreichbaren Emissionslebensdauern mit einigen Mikrosekunden recht lang sind und damit das oben beschriebene Roll-Off-Verhalten der Effizienz zeigen.

Die DE 10 2008 033 563 A1 offenbart Metallkomplexe mit kleinen Singulett-Triplett-Energie-Abständen zur Verwendung in opto-elektronischen Bauteilen. Die US 2002/0008233 A1 beschreibt Intersystem Crossing Agentien für eine effiziente Verwendung von Excitonen in organischen Licht emittierenden Vorrichtungen

Weiterhin offenbart die US amerikanische Patentschrift US 7,416,791 B1 Osmiumkomplexe und verwandte organische Licht emittierende Vorrichtungen.

Die den Singulett-Harvesting-Effekt zeigende Blaulichtemitter zur Verwendung in OLEDs und anderen organisch-elektronischen Vorrichtungen sind aus der internationalen Veröffentlichungsschrift WO 2011/089163 A1 bekannt.

## Beschreibung der Erfindung

Überraschender Weise lässt sich die oben beschriebene Problematik durch die vorliegende Erfindung wesentlich verbessern bzw. lösen, wobei organische Moleküle (Farbstoffe, Emitter-Moleküle) zur Verwendung kommen, die bestimmte elektronische Strukturen bzw. Singulett-Triplett-Energieabstände aufweisen und die erfindungsgemäß durch Veränderungen in der unmittelbaren Umgebung der Emitter modifiziert werden. Dieses Verfahren des hier erstmals vorgeschlagenen "Singulett-Harvestings für organische Emitter" soll im Folgenden unter Verwendung der Fig. 2 kurz beschrieben werden:

Fig. 2a zeigt ein (vereinfachtes) Energieniveauschema für ein typisches, rein organischen Molekül, das einen $\Delta E(S_1\text{-}T_1)$-Wert zwischen dem untersten angeregten Singulett- ($S_1$) und dem darunter liegenden Triplett-Zustand ($T_1$) von größer als 2500 $cm^{-1}$ aufweist.

Anhand dieses Schemas lassen sich die photo-physikalischen Elektrolumineszenz-Eigenschaften dieser Moleküle erläutern. Die Loch-Elektron-Rekombination, wie sie beispielsweise in einem optoelektronischen Bauelement erfolgt, führt im statistischen Mittel zu 25 % zur Besetzung des Singulett-Zustandes und zu 75 % zur Besetzung der drei Unterzustände des Triplett-Zustandes. Da der Emissions-Übergang aus dem Triplett- $T_1$ in den Singulett- $S_0$ Zustand bei organischen Molekülen wegen der geringen Spin-Bahn-Kopplung stark spin-verboten ist, wird die in den Triplett gelangende Anregungsenergie strahlungslos in Wärme umgewandelt und ist damit für die Licht-Erzeugung durch Elektro-Lumineszenz verloren. Der besetzte Singulett-Zustand kann allerdings eine effektive Emission (Fluoreszenz) zeigen,

weil es sich um einen spin-erlaubten Singulett-Singulett-Übergang handelt. In diesem Zusammenhang ist es wichtig zu erwähnen, dass der strahlungslose Relaxationsprozess aus dem $S_1$-Zustand in den $T_1$-Zustand, der sogenannte Inter-System-Crossing (ISC) Prozess, ebenfalls wegen der geringen Spin-Bahn-Kopplung stark verboten ist. Andernfalls würde keine Fluoreszenz beobachtbar sein. Für die Zeitkonstanten bedeutet das, dass $\tau_1$(ISC) um Größenordnungen länger ist als die Fluoreszenzlebensdauer, die im Bereich von einer bis zu einigen Nanosekunden für $\tau(S_1)$ liegt.

Erfindungsgemäß lassen sich die oben beschriebenen Nachteile des Standes der Technik vermeiden. Das gelingt unter Kombination von zwei Schritten:

I. Es werden organische Moleküle mit hoher Emissionsquantenausbeute (größer 50 %) bereitgestellt, deren Energiedifferenz zwischen dem Singulett $S_1$ und dem Triplett $T_1$ so klein ist, so dass bei Raumtemperatur eine thermische Rückbesetzung vom Triplett $T_1$ in den Singulett $S_1$ möglich ist, wodurch die Triplett-Anregung über den Singulett $S_1$ Zustand in Licht umgewandelt werden kann. Das gelingt erfindungsgemäß unter Verwendung rein organischer Moleküle, die kein Metallatom oder Metallion aufweisen, wie etwa unter Verwendung von organischen Molekülen der Formeln I, II und III.

II. Die extrem lange Inter-System-Crossing Zeitkonstante ($\tau$(ISC)) von rein organischen Molekülen wird, um eine ausreichend schnelle thermische Rückbesetzung zu ermöglichen, um einige Größenordnungen verkürzt. Das ist durch eine Verstärkung der Spin-Bahn-Kopplung insbesondere durch zusätzliches Einbringen von Atomen oder Molekülen möglich, die eine hohe Spin-Bahn-Kopplung tragen. Dem Chemiker ist dieser Effekt als "externer Schweratomeffekt" bekannt. Dieses Verfahren wird weiter untern erläutert.

Unter diesen beiden, gemeinsam einzusetzenden Strategien lassen sich - wie anhand der Fig. 2b erläutert wird - die bei der Elektro-Lumineszenz-Anregung besetzten Triplett- und Singulett-Anregungen sammeln und über den Singulett-Zustand $S_1$ in Licht umwandeln. Dieses hier erstmals beschriebene Verfahren des Singulett-Harvesting-Effektes für organische Moleküle wird im Folgenden genauer erläutert.

Demgemäß sieht die Erfindung in einem Aspekt eine Zusammensetzung, insbesondere zur Benutzung in einer optoelektronischen Vorrichtung vor, die

- ein organisches Emitter-Molekül mit einem untersten angeregten Singulett- ($S_1$) und einem darunter liegenden Triplett-Zustand ($T_1$) aufweist, wobei der $\Delta E(S_1-T_1)$-Wert des organischen Moleküls kleiner als 2500 $cm^{-1}$ ist, wobei das organische Molekül kein Metall-atom oder Metallion aufweist und
- ein optisch inertes Atom oder Molekül aufweist, das derart mit dem organischen Molekül in Wechselwirkung tritt, dass die Inter-System-Crossing Zeitkonstante des organisches Moleküls auf kleiner als $10^{-6}$ s, bevorzugt auf kleiner als $10^{-8}$ s, besonders bevorzugt auf kleiner als $10^{-9}$ s reduziert wird. Dies kann in einer bevorzugten Ausgestaltung durch ein optisch inertes Atom oder Molekül oder Molekül-Komponenten erfolgen, das oder die eine hohe Spin-Bahn-Kopplung aufweist/aufweisen. Diese lässt sich durch die Spin-Bahn-Kopplungskonstante beschreiben, die höher als etwa 200 $cm^{-1}$, bevorzugt höher als 1000 $cm^{-1}$ und besonders bevorzugt höher als 2000 $cm^{-1}$, ganz besonders bevorzugt größer 4000 $cm^{-1}$ sein sollte.

Die Begriffe "Spin-Bahn-Kopplungskonstante" und "Inter-System-Crossing Zeitkonstante" sind Fachbegriffe, die in der photophysikalischen Literatur gängig verwendet werden und daher dem Fachmann bekannt sind.

**Moleküle mit kleinen $\Delta E(S_1-T_1)$-Abständen**

In Fig. 2b ist ein Energieniveau-Diagramm für ein organisches Molekül mit kleiner Energiedifferenz $\Delta E(S_1-T_1) < 2500$ $cm^{-1}$ dargestellt. Diese Energiedifferenz ist klein genug, um eine thermische Rückbesetzung des $S_1$-Zustandes aus dem $T_1$-Zustand gemäß einer Boltzmann-Verteilung, bzw. gemäß der thermischen Energie $k_BT$, und damit eine thermisch aktivierte Lichtemission aus dem $S_1$-Zustand zu ermöglichen. Dieser Vorgang wird durch Gleichung (1) gesteuert

$$\mathrm{Int}(S_1 \rightarrow S_0) / \mathrm{Int}(T_1 \rightarrow S_0) = k(S_1) / k(T_1) \exp(-\Delta E/k_BT) \quad (1)$$

Hierin stellt $\mathrm{Int}(S_1 \rightarrow S_0) / \mathrm{Int}(T_1 \rightarrow S_0)$ das Intensitätsverhältnis der Emissionen aus dem $S_1$-Zustand bzw. dem $T_1$-Zustand dar. $k_B$ ist die Boltzmann-Konstante und T die absolute Temperatur. $k(S_1) / k(T_1)$ ist das Ratenverhältnis der Übergangsprozesse aus dem Singulett $S_1$ und aus dem Triplett $T_1$ in den elektronischen Grundzustand $S_0$. Für organische Moleküle liegt dieses Verhältnis zwischen $10^7$ bis $10^{10}$. Erfindungsgemäß bevorzugt sind Moleküle mit einem Ratenverhältnis von etwa $10^8$, besser von etwa $10^9$, besonders bevorzugt von etwa $10^{10}$. $\Delta E$ steht für die Energiedifferenz

$\Delta E_2(S_1\text{-}T_1)$ gemäß Fig. 2 b.

Durch den beschriebenen Prozess der thermischen Rückbesetzung wird aus dem besetzten Triplett ein Emissionskanal über den Singulett-Zustand $S_1$ geöffnet. Da der Übergang aus dem $S_1$- in den $S_0$- Zustand stark erlaubt ist, wird die sonst verlorene Triplett-Anregungsenergie praktisch vollständig als Lichtemission über den Singulett-Zustand gewonnen. Dieser Effekt ist bei vorgegebener Temperatur, z. B. bei Raumtemperatur, umso ausgeprägter, je kleiner die Energiedifferenz $\Delta E$ ist. Daher sind organische Moleküle bevorzugt, die einen $\Delta E = \Delta E(S_1\text{-}T_1)$-Wert zwischen dem untersten angeregten Singulett-und dem darunter liegenden Triplett-Zustand von kleiner als 2500 $cm^{-1}$, besser kleiner als 1500 $cm^{-1}$, bevorzugt von kleiner als 1000 $cm^{-1}$ aufweisen.

Anhand eines Zahlenbeispiels soll dieser Effekt erläutert werden. Bei einer Energiedifferenz von $\Delta E$ = 1300 $cm^{-1}$ ergibt sich für Raumtemperaturanwendungen (T = 300 K) mit $k_BT$ = 210 $cm^{-1}$ und einem Ratenverhältnis von $10^8$ ein Intensitätsverhältnis der Singulett- zur Triplett-Emission gemäß Gleichung (1) von ca. $2{\cdot}10^5$. Das heißt, der Singulett-Emissionsprozess dominiert für ein Molekül mit diesen Beispielwerten extrem.

Die Emissionslebensdauer dieses Beispiel-Moleküls verändert sich auch deutlich. Durch die thermische Rückbesetzung ergibt sich eine mittlere Lebensdauer $\tau_{av}$. Diese lässt sich gemäß Gleichung (2) beschreiben

$$\tau_{av} \approx \tau(S_1) \cdot \exp\,(\Delta E / k_BT) \qquad (2)$$

Hierin ist $\tau(S_1)$ die Fluoreszenzlebensdauer ohne Rückbesetzung und $\tau_{av}$ die Emissionslebensdauer, die bei Öffnung des Rückbesetzungskanals durch die beiden Zustände $T_1$ und $S_1$ bestimmt wird. (Siehe Fig. 2b) Die anderen Größen wurden oben definiert.

Gleichung (2) soll wieder durch ein Zahlenbeispiel erläutert werden. Für die angenommene Energiedifferenz von $\Delta E$ = 1300 $cm^{-1}$ und einer Abklingzeit des fluoreszierenden $S_1$ - Zustandes von 1 ns ergibt sich eine Emissionsabklingzeit (der beiden Zustände, d. h. des thermisch aus dem $T_1$-Zustand rück-besetzten $S_1$-Zustandes) von $\tau_{av} \approx 500$ ns. Diese Abklingzeit ist bereits wesentlich kürzer, als die von sehr guten Triplett-Emittern, deren Abklingzeiten im Bereich von ca. 1,5 $\mu$s bis 10 $\mu$s liegen.

Die Anwendbarkeit der Gleichung (2) bzw. die Gültigkeit der oben beschriebenen Berechnung der Abklingzeit $\tau_{av}$ erfordert erfindungsgemäß die Verwendung von Zusatzstoffen, die die Spin-Bahn-Kopplung erhöhen (für detaillierte Ausführungen siehe z. B. weiter unten). Diese Zusatzstoffe, d. h. optisch inerte Atome oder Moleküle der Zusammensetzung, treten derart mit den organischen Emitter-Molekülen in Wechselwirkung, dass die mittlere (av, thermalisierte) Emissionslebensdauer der beiden Zustände $S_1$ und $T_1$ des organischen Moleküls auf etwa 500 ns reduziert wird. Bevorzugt sind Zusammensetzungen derart, dass die Emissionslebensdauer auf kleiner 1 $\mu$s, bevorzugt auf kleiner 600 ns und besonders bevorzugt auf kleiner 200 ns reduziert wird.

Zusammenfassend lassen sich also unter Verwendung dieses "Singulett-Harvesting-Verfahrens für organische Moleküle" im Idealfall nahezu sämtliche, d. h. maximal 100 % der Exzitonen erfassen und über eine Singulett-Emission in Licht umwandeln. Darüber hinaus gelingt es, die Emissionsabklingzeit deutlich unter den Wert für Triplett-Emitter, der bei einigen Mikrosekunden liegt, zu verkürzen. Daher ist die erfindungsgemäße Zusammensetzung für optoelektronische Bauelemente besonders geeignet.

Organische Moleküle mit den oben beschriebenen Eigenschaften, d. h. mit kleiner Singulett-Triplett-Energiedifferenz $\Delta E$ ($S_1$-$T_1$), sind bevorzugt organische Moleküle mit folgenden generellen Formeln I bis III.

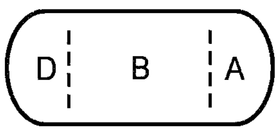


Formel I

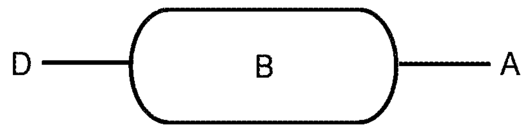


Formel II

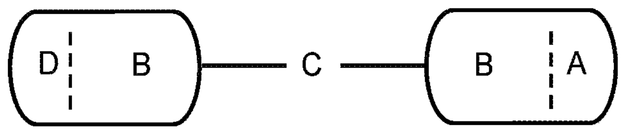


Formel III

Hierin bedeutet D eine chemische Gruppe oder steht für einen Substituenten mit elektronen-schiebender Wirkung (D, Donator-Wirkung). Substituenten dieser Art können einfach, zweifach oder mehrfach vorhanden sein. Sie können gleich oder verschieden sein.

A steht für eine chemische Gruppe oder einen Substituenten mit elektronen-ziehenden Eigenschaft (A, Akzeptor-Wirkung). Substituenten dieser Art können einfach, zweifach oder mehrfach vorhanden sein. Sie können gleich oder verschieden sein.

Das Grundgerüst B ist aufgebaut aus konjugierten organischen Gruppen, die aus aromatischen, heteroaromatischen und/oder konjugierten Doppelbindungen bestehen.

Beispiele für Donatoren D:

-O(-), -N-Alkylgruppe, -N-(Alkylgruppe)$_2$ -$NH_2$, -OH, -O-Alkylgruppe, -NH(CO)-Alkylgruppe, -O(CO), - Alkylgruppe, -Alkylgruppe, -Phenylgruppe, -(CH)=C-(Alkylgruppe)$_2$

Beispiele für Akzeptoren A:

- Halogen, -(CO)H, -(CO)-Alkylgruppe, -(CO)O-Alkylgruppe, -(CO)OH, -(CO)Cl, -$CF_3$, -CN, -S(O)$_2$OH, -$NH_3$(+),-N(Alkylgruppe)$_3$(+), N(O)$_2$

Aufbau des Grundgerüstes B:

B ist aufgebaut aus konjugierten organischen Gruppen, die aus aromatischen, heteroaromatischen und/oder konjugierten Doppelbindungen bestehen. Bevorzugt sind Molekül-Grundgerüste B mit aromatischen oder heteroaromatischen Ringen kleiner 15, besonders bevorzugt kleiner 10, ganz besonders bevorzugt kleiner sieben. Die aromatischen oder heteroaromatischen Ringe sind chemisch direkt verknüpft oder über Alkenyl-Gruppen mit konjugierten Doppelbindungen kleiner 10, besonders bevorzugt kleiner sechs und ganz besonders bevorzugt kleiner 3 chemisch verbunden.

Beispiele für verknüpfende Gruppen C:

Bevorzugt sind chemisch gebundene Alkenyl-Gruppen mit einer Anzahl von konjugierten Doppelbindungen kleiner 10, besonders bevorzugt kleiner sechs und ganz besonders bevorzugt kleiner 3.

Die durch Formeln I bis III beschriebenen organischen Moleküle weisen $\Delta E(S_1\text{-}T_1)$-Werte zwischen dem untersten angeregten Singulett- und dem darunter liegenden Triplett-Zustand von kleiner als 2500 $cm^{-1}$, bevorzugt kleiner als 1500 $cm^{-1}$ und besonders bevorzugt kleiner 1000 $cm^{-1}$ auf. Auf Verfahren zur Messung bzw. rechnerischen Bestimmung der $\Delta E(S_1\text{-}T_1)$-Werte wird weiter unten eingegangen.

Bevorzugt sind organische Moleküle, die ohne Verwendung von Zusatzstoffen eine hohe Fluoreszenz-Quantenausbeute aus dem $S_1$-Zustand von größer 50 %, bevorzugt größer 70 %, besonders bevorzugt größer 90 % aufweisen (Bestimmung mit handelsüblichen Emissionsquantenausbeute-Meßgeräten) und bei denen die Absorptionsstärken, d. h. die molaren dekadischen Extinktionskoeffizienten der Übergänge zwischen dem Grundzustand So und dem ange-

regten Zustand $S_1$ größer als $10^4$ l/mol cm, bevorzugt größer $2x10^4$ l/mol cm, besonders bevorzugt größer als 5x104 l/mol cm sind (Bestimmung mit handelsüblichen Absorptionsspektrometern).

Die Erfindung betrifft in einem weiteren Aspekt ein Verfahren zur Auswahl von organischen Molekülen, deren $\Delta E(S_1-T_1)$-Wert zwischen dem untersten angeregten Singulett-($S_1$) und dem darunter liegenden Triplett-Zustand ($T_1$) kleiner als 2500 $cm^{-1}$, bevorzugt kleiner als 1500 $cm^{-1}$, besonders bevorzugt kleiner als 1000 $cm^{-1}$ ist.

Die Bestimmung des $\Delta E(S_1-T_1)$-Wertes kann sowohl durch quantenmechanische Berechnungen mittels im Stand der Technik bekannten Computerprogrammen durchgeführt werden (z. B. mittels Turbomole-Programmen unter Ausführung von TDDFT- und unter Berücksichtigung von CC2-Rechnungen) oder - wie weiter unten erläutert wird - experimentell bestimmt werden.

Die Energiedifferenz $\Delta E(S_1-T_1)$, insbesondere der durch Formeln I bis III beschriebenen organischen Moleküle, lässt sich näherungsweise quantenmechanisch durch das mit dem Faktor 2 multiplizierte sogenannte Austauschintegral beschreiben. Dessen Wert hängt direkt ab von der Überlappung der Molekülorbitale im D-seitigen Bereich von B mit den Molekülorbitalen im A-seitigen Bereich von B. Diese Molekülorbitale sind wegen der oben beschriebenen Eigenschaften von D bzw. A über unterschiedliche Raumbereiche verteilt (teil-delokalisiert über $\pi$- bzw. $\pi^*$-Molekülorbitale). Das heißt, ein elektronischer Übergang zwischen den verschiedenen Molekülorbitalen repräsentiert einen sogenannten Charge-Transfer (CT)-Übergang. Je geringer die Überlappung der oben beschriebenen Molekülorbitale ist, desto ausgeprägter ist der elektronische Charge-Transfer Charakter. Das ist dann mit einer Abnahme des Austausch-Integrals und somit einer Abnahme der Energiedifferenz $\Delta E(S_1-T_1)$ verbunden. Mit anderen Worten, $\Delta E(S_1-T_1)$ kann über die Stärken der elektronen-schiebenden bzw. -ziehenden Substituenten/Gruppen des organischen Moleküls verändert werden. Aufgrund dieser photophysikalischen (quantenmechanischen) Eigenschaften lassen sich die erfindungsgemäßen Energiedifferenzen mit $\Delta E(S_1-T_1)$ kleiner 2500 $cm^{-1}$ oder kleiner 1500 $cm^{-1}$ oder kleiner 1000 $cm^{-1}$ erreichen.

Die Bestimmung des $\Delta E(S_1-T_1)$-Wertes kann experimentell folgendermaßen erfolgen:

Für ein vorgegebenes organisches Molekül lässt sich der Energieabstand $\Delta E(S_1-T_1) = \Delta E$ unter Verwendung der oben angegebenen Gleichung (1) einfach bestimmen. Eine Umformung ergibt:

$$\ln\{Int(S_1 \rightarrow S_0)/Int(T_1 \rightarrow S_0)\} = \ln\{k(S_1)/k(T_1)\} - (\Delta E/k_B)(1/T) \qquad (3)$$

Für die Messung der Intensitäten $Int(S_1 \rightarrow S_0)$ und $Int(T_1 \rightarrow S_0)$ kann jedes handelsübliche Spektralphotometer verwendet werden. Eine graphische Auftragung der bei verschiedenen Temperaturen gemessenen (logarithmierten) Intensitätsverhältnisse $\ln\{Int(S_1 \rightarrow S_0)/Int(T_1 \rightarrow S_0)\}$ gegen den Kehrwert der absoluten Temperatur T ergibt in der Regel eine Gerade. Die Messung wird in einem Temperaturbereich von Raumtemperatur (300 K) bis 77 K oder bis 4,2 K durchgeführt, wobei die Temperatur mittels eines Kryostaten eingestellt wird. Die Intensitäten werden aus den (korrigierten) Spektren bestimmt, wobei $Int(S_1 \rightarrow S_0)$ bzw. $Int(T_1 \rightarrow S_0)$ die integrierten Fluoreszenz- bzw. Phosphoreszenz-Bandenintensitäten repräsentieren, welche sich mittels der zum Spektralphotometer gehörenden Programme bestimmen lassen. Die jeweiligen Übergänge (Bandenintensitäten) lassen sich leicht identifizieren, da die Triplett-Bande bei niedrigerer Energie liegt als die Singulett-Bande und mit sinkender Temperatur an Intensität gewinnt. Dabei werden die Messungen in sauerstofffreien verdünnten Lösungen (ca. $10^{-2}$ mol $L^{-1}$) oder an dünnen Filmen aus den entsprechenden Molekülen oder an mit den entsprechenden Molekülen dotierten Filmen durchgeführt. Verwendet man als Probe eine Lösung, so empfiehlt es sich, ein Lösemittel bzw. Lösemittelgemisch zu verwenden, das bei tiefen Temperaturen Gläser bildet, wie 2-Methyl-THF, THF (Tetrahydrofuran) oder aliphatische Kohlenwasserstoffe. Verwendet man als Probe einen Film, so eignet sich die Verwendung einer Matrix mit einer deutlich größeren Singulett- sowie Triplett-Energie als die der organischen Emittermoleküle, z. B. PMMA (Polymethylmethacrylat). Dieser Film kann aus Lösung aufgebracht werden. Besonders wichtig ist, dass - wie unten beschrieben - die zu analysierenden Moleküle mit den jeweiligen Zusatzstoffen verwendet werden.

Die Geradensteigung beträgt-$\Delta E/k_B$. Mit $k_B = 1{,}380\ 10^{-23}\ JK^{-1} = 0{,}695\ cm^{-1}\ K^{-1}$ lässt sich der Energieabstand direkt bestimmen.

Eine äquivalente Betrachtungsweise zeigt, dass mittels der Messung der Temperaturabhängigkeit der Emissionsabklingzeit der $\Delta E(S_1-T_1)$-Wert auch bestimmt werden kann.

Eine einfache, näherungsweise Abschätzung des $\Delta E(S_1-T_1)$-Wertes kann auch dadurch vorgenommen werden, dass bei tiefer Temperatur (z. B. 77 K oder 4.2 K unter Verwendung eines Kryostaten) die Fluoreszenz- und Phosphoreszenz-Spektren registriert werden. Der $\Delta E(S_1-T_1)$-Wert entspricht dann in Näherung der Energiedifferenz zwischen den hoch-energetischen Anstiegsflanken der Fluoreszenz- bzw. Phosphoreszenz-Bande.

Je ausgeprägter der CT-Charakter eines organischen Moleküls ist, desto stärker verändern sich die elektronischen Übergangsenergien als Funktion der Lösungsmittelpolarität. So gibt bereits eine ausgeprägte Polaritätsabhängigkeit der Emissionsenergien einen Hinweis auf das Vorliegen kleiner $\Delta E(S_1-T_1)$-Werte.

**Zusatzstoffe / Verringerung der Inter-System-Crossing-Zeitkonstante**

Bevorzugte organische Moleküle bestehen ausschließlich aus leichten Atomen wie C, H, N, O, F, S, K, Na. Für derartige organische Moleküle, deren elektronische Singulett- und Triplett-Zustände im Wesentlichen aus Übergängen zwischen $\pi$- und $\pi$*-Molekülorbitalen resultieren, ist - wie bereits erwähnt - die wirksame Spin-Bahn-Kopplung (SBK) so klein, dass die Relaxationsübergänge aus dem $S_1$- in den energetisch tiefer liegenden $T_1$-Zustand und umgekehrt aus dem $T_1$-Zustand in den $S_1$-Zustand kaum auftreten (stark verboten sind).

Erfindungsgemäß wird dieses Verbot aufgehoben: Die organischen Moleküle (Emitter-Moleküle), insbesondere solche der Formeln I,II und III, können, z. B. in opto-elektronischen Vorrichtungen, in Matrixmaterialien, z. B. in einer OLED-Emissionsschicht, eindotiert sein. Dieser Matrix werden erfindungsgemäß optisch inerte Atome oder Moleküle (sog. "Zusatzstoffe") zur Reduktion der Inter-System-Crossing Zeitkonstante des organisches Moleküls zugemischt. Diese optisch inerten Atome oder Moleküle zeichnen sich durch eine hohe Spin-Bahn-Kopplung (SBK) aus (SBK-Konstante der Atome oder Molekülbausteine größer 1000 $cm^{-1}$, siehe dazu die weiter unten gegebenen Erläuterungen). Diese Zusatzstoffe werden zum Beispiel in einer Konzentration eingebracht, die etwa der der Emitter-Moleküle entspricht oder höher ist. Die Zusatzstoffe können z. B. auch in doppelt bis fünffach so hoher Konzentration wie die organischen Emittermoleküle verwendet werden. Allgemein ist das numerische Verhältnis zwischen organischen Emitter-Molekülen und optisch inerten Atomen oder Molekülen 1 : 0,1 bis 1 : 5 oder 1 : 10, bevorzugt 1 : 0,2 bis 1 : 5, besonders bevorzugt 1:1. Damit ist die Verteilungs-Wahrscheinlichkeit gegeben, dass mindestens ein Zusatzteilchen/Zusatzmolekül mit hoher SBK in nächster Nachbarschaft eines Emitter-Moleküls liegt. Hierdurch wird eine externe SBK induziert, die den Prozess des Inter-System-Crossings um mehrere Zehnerpotenzen beschleunigt. Das bewirkt eine sehr schnelle Relaxation vom $S_1$- zum $T_1$-Zustand und ebenso eine sehr schnelle thermische Rückbesetzung gemäß den Gleichungen (1) und (2). Damit wird der Singulett-Harvesting-Effekt für organische Moleküle ermöglicht.

Beispiele für die Zusatzstoffe sind:

- Edelgase (besonders bevorzugt):

  Krypton (Kr) aber besonders bevorzugt Xenon (Xe). Diese Gase werden während des Herstellungsprozesses eines optoelektronischen Bauelements in die mit den Emitter-Molekülen dotierte Matrix, die zur Ausbildung der Emissionsschicht verwendet wird, eingeleitet. Dabei ist auf eine Gassättigung bei einem Gasdruck von einer Atmosphäre (1013.25 hPa), gegebenenfalls unter erhöhtem Gasdruck von bis etwa 3 atm (ca. 300 kPa), z. B. von etwa 2 atm (ca. 200 kPa), zu achten. Die Emissionsschicht wird unter dieser Gasatmosphäre zum Beispiel über Spin-Coating oder andere nass-chemische Verfahren aufgebracht.

- Brom- und Jod-haltige Substanzen, wobei Jod-haltige Substanzen besonders bevorzugt sind.
  Der zur Herstellung der Emissionsschicht eines optoelektronischen Bauelements verwendeten Lösung werden Br- oder besonders bevorzugt I-haltige Substanzen zugegeben, zum Beispiel Alkyl-Bromide, Alkyl-Jodide (z. B. Ethyljodid, Propyljodid), Aryl-Bromid, Aryl-Jodid (z. B. Naphthyljodid)
  Opto-elektronische Vorrichtungen unter Verwendung dieser Zusatzstoffe werden nass-chemisch hergestellt.
- Das Matrixmaterial der Emissionsschicht eines optoelektronischen Bauelements kann aus Brom-, aber besonders bevorzugt aus Jod-haltigen Substanzen oder Polymergebundenem Br oder I bestehen oder diese Substanzen aufweisen. Diese Halogene können sich auch in chemisch gebundener Form in den Polymerseitengruppen befinden. Opto-elektronische Vorrichtungen unter Verwendung dieser Zusatzstoffe werden nass-chemisch hergestellt.
- Als Zusatzstoffe eignen sich auch Nanoteilchen aus Metallatomen der zweiten oder bevorzugt der dritten Periode der Übergangsmetalle oder Gadolinium. Opto-elektronische Vorrichtungen unter Verwendung dieser Zusatzstoffe werden nass-chemisch oder über Vakuum- oder über Vaporphase-Deposition-Verfahren hergestellt.
- Bevorzugt als Zusatzstoffe sind Gd-Komplexe. Diese können den bei der Herstellung verwendeten Lösungen der Emissionsschichten für nass-chemische Verarbeitungen beigemischt werden oder für den Fall der Herstellung der opto-elektronischen Vorrichtungen mittels Vakuum-Sublimation oder Vaporphase-Deposition co-verdampft werden. Besonders bevorzugt sind chemisch stabile Gd-Komplexe, die in dem für die Anwendung benötigten Spektralbereich optisch inert sind. Beispiele sind: $Gd(Cyclopentadien)_3$, $Gd(Tetramethylheptadien)_3$, Gd-Acetat, $Gd(acac)_3$, $Gd(TMHD)_3$, Gd-2-Ethylhexanoat usw. Gd-Ionen gelten als optisch inert und können in einem weiteren Aspekt der Erfindung eingesetzt werden.
- Als Zusatzstoffe eignen sich allgemein Atome oder Moleküle oder Nano-Teilchen, die im Emissions- bzw. relevanten HOMO-/LUMO-Bereich des Emitters keine Absorptionen oder Emissionen aufweisen und somit in diesen Bereichen optisch als optisch inert gelten. Die Zusatzstoffe, bzw. deren atomare Bausteine, sollen außerdem eine hohe SBK-Konstante aufweisen, die bevorzugt größer 1000 $cm^{-1}$, besonders bevorzugt größer 3000 $cm^{-1}$ ganz besonders bevorzugt größer 4000 $cm^{-1}$ ist.

### OLED-Devices

In einem weitern Aspekt der Erfindung wird die hier beschrieben Zusammensetzung in einer Emitterschicht in einer optoelektronischen (organisch elektronischen) Vorrichtung, insbesondere einer OLED verwendet.

Die OLED-Devices können nach aus dem Stand der Technik bekannten Verfahren hergestellt werden (vergleiche H. Yersin, "Highly Efficient OLEDs with Phosphorescent Materials", Wiley-VCH, Weinheim, Germany 2008).

Bei einer bevorzugten Ausgestaltung einer organischen Leuchtidiode (OLED) beträgt der Anteil der Zusammensetzung (organischer Emitter und Zusatzstoff) in der Emitterschicht zwischen 2 Gew.-% und 100 Gew.-%, bevorzugt zwischen 6 Gew.-% und 30 Gew.-%.

### Weitere optoelektronische Vorrichtungen

Ein anderer Aspekt der Erfindung ist die Verwendung der erfindungsgemäßen Zusammensetzung aus organischem Molekül und optisch inertem Atom oder optisch inertem Molekül zum Einsatz in Licht emittierenden elektrochemischen Zellen (light emitting electro-chemical cells, LEECs), OLED-Sensoren, insbesondere in einem nicht hermetisch nach außen abgeschirmten Gas- und Dampf-Sensor, optischen Temperatur-Sensoren, organischen Solarzellen (organic solar cells, OSCs; organic photovoltaics, OPVs), organischen Feldeffekttransistoren, organischen Dioden, organischen Photodioden und "down conversion" Systemen.

Generell kann der Anteil der Zusammensetzug in einer Emitterschicht einer optoelektronischen Vorrichtung 2 bis 100 Gew.-%, bevorzugt 6 bis 30 Gew.-%, bezogen auf das Gesamtgewicht der Emitterschicht, betragen.

In einem weiteren Aspekt betrifft die Erfindung ein Verfahren zur Verringerung der Emissionslebensdauer und ein Verfahren zur Erhöhung der Elektrolumineszenz-Quantenaubeute eines organischen Moleküls als Emitter in einer optoelektronischen Vorrichtung. Dabei wird ein organisches Molekül, das in einen $\Delta E(S_1\text{-}T_1)$-Wert zwischen dem untersten angeregten Singulett- ($S_1$) und dem darunter liegenden Triplett-Zustand ($T_1$) von kleiner als 2500 $cm^{-1}$ aufweist, in die Nähe eines optisch inerten Atoms oder Moleküls verbracht (gegebenenfalls über eine chemische Bindung), so dass das organische Molekül mit dem optisch inerten Atoms oder Molekül in Wechselwirkung treten kann. Aufgrund einer Spin-Bahn-Kopplungs-Konstanten von größer 1000 $cm^{-1}$ des optisch inerten Atoms oder Moleküls oder von Teilen des optisch inerten Moleküls wird eine kurze mittlere Emissionslebensdauer (aus dem Singulett $S_1$- und dem Triplett $T_1$-Zustand) des organischen Moleküls sowie eine Erhöhung der Emissions-Quantenaubeute erreicht.

Die Erfindung betrifft weiterhin ein Verfahren zur Umwandlung der bei der Elektrolumineszenz generierten Triplett-Anregungsenergie eines organischen Moleküls in Fluoreszenzenergie. Dabei wird ein organisches Molekül, das einen $\Delta E(S_1\text{-}T_1)$-Wert zwischen dem untersten angeregten Singulett- ($S_1$) und dem darunter liegenden Triplett-Zustand ($T_1$) von kleiner als 2500 $cm^{-1}$ aufweist, derart mit einem optisch inerten Atom oder Molekül in Wechselwirkung gebracht, dass eine Triplett-Anregungsenergie des organischen Moleküls über einen Singulettzustand des organischen Moleküls in Fluoreszenzenergie umgewandelt wird.

Die Erfindung betrifft auch ein Verfahren zur Auswahl von organischen Molekülen, deren $\Delta E(S_1\text{-}T_1)$-Wert zwischen dem untersten angeregten Singulett- ($S_1$) und dem darunter liegenden Triplett-Zustand ($T_1$) kleiner als 2500 $cm^{-1}$, bevorzugt kleiner als 1500 $cm^{-1}$, besonders bevorzugt kleiner als 1000 $cm^{-1}$ ist. Das Verfahren umfasst mindestens zwei Schritte, nämlich: erstens die Bestimmung des $\Delta E(S_1\text{-}T_1)$-Wertes organischer Moleküle mittels a) einer ab-initio Molekülrechnung, b) Messung der Temperaturabhängigkeit der Fluoreszenz- und der Phosphoreszenz-Intensität, oder c) der Messung der Temperaturabhängigkeit der Emissionsabklingzeit, und
zweitens die Ermittlung der von organischen Molekülen, deren $\Delta E(S1\text{-}T1)$-Wert kleiner als 2500 $cm^{-1}$, bevorzugt kleiner als 1500 $cm^{-1}$, besonders bevorzugt kleiner als 1000 $cm^{-1}$ ist. Die so ermittelten organischen Moleküle, weisen einen $\Delta E(S_1\text{-}T_1)$-Wert zwischen dem untersten angeregten Singulett- ($S_1$) und dem darunter liegenden Triplett-Zustand ($T_1$) von kleiner als 2500 $cm^{-1}$, bevorzugt kleiner als 1500 $cm^{-1}$, besonders bevorzugt kleiner als 1000 $cm^{-1}$ auf.

### Beispiele

Aus der Vielzahl der realisierbaren organischen Molekülen mit kleiner Singulett $S_1$-Triplett $T_1$-Energiedifferenz seien am Beispiel der Emitter gemäß den Formeln I bis III einige Beispiele aufgeführt, die folgende Eigenschaften aufweisen:

- Die Materialien stellen sehr gute Emitter dar.
- Die Absorptions- und Fluoreszenz-Übergänge zwischen den Zuständen $S_O$ und $S_1$ sind stark erlaubt. Damit sind die Emissionsabklingzeiten $\tau(S_1)$ sehr kurz.
- Die Beispiele umfassen Moleküle mit Emissionen aus dem weiten Spektralbereich vom nahen UV- bis zum nahen IR-Bereich. Insbesondere ist es damit auch möglich, gute Blau-Licht-Emitter zu realisieren.

In der Fig. 3 (A bis I) sind diverse Beispiele zusammengefasst.

Insbesondere zeigt die Einbringung von oben aufgelisteten inerten Zusatzstoffen, dass die Inter-Sytem-Crossing(ISC)-Zeiten der Übergänge zwischen dem Singulett $S_1$ und dem Triplett $T_1$ der organischen Emitter-Moleküle drastisch verringert - oder gleichbedeutend die ISC-Raten drastisch erhöht - werden können. Beispielsweise wurden diverse organische Emitter-Moleküle, ausgewählt aus den in Figur 3 gezeigten Beispielen, in reiner Form in PMMA dotiert und per Spin-Coating auf ein Glassubstrat aufgebracht. In einem weiteren Ansatz wurden zusätzlich zu den Emitter-Molekülen optisch inerte Zusatzstoffe (z. B. Naphthyljodid oder Gd(III)acetat) im Molverhältnis 1 : 1 bzw. 1 : 5 (Emitter-Molekül : Zusatzstoff) eingebracht. Analysen der Veränderungen des Emissionsverhaltens der beiden Ansätze zeigen, dass durch die Zusatzstoffe die ISC-Raten um etwa den Faktor hundert bzw. tausend erhöht werden. Das bedeutet, dass die Zusatzstoffe die Spin-Bahn-Kopplung am Emitter-Molekül tatsächlich wirksam verstärkt.

**Figuren**

Figur 1: Prinzipieller Aufbau eines OLEDs. Die Abbildung ist nicht maßstabsgerecht gezeichnet.

Figur 2: Erläuterungen des Elektro-Lumineszenz-Verhaltens a für typische organische Moleküle nach dem Stand der Technik und b für erfindungsgemäß selektierte Moleküle, die in ihrer unmittelbaren Umgebung durch Zusatzstoffe modifiziert sind, um das "Singulett-Harvesting-Verfahren für organische Moleküle" zu ermöglichen.

Figur 3A bis I zeigt eine Auflistung von Beispielen für das organische Molekül, das Bestandteil der erfindungsgemäßen Zusammensetzung ist.

Diverse Beispiele enthalten geladene organische Moleküle und Gegenionen. Diese Emittermoleküle können bevorzugt in licht-emittierenden elektrochemischen Zellen (LEECs oder LECs) eingesetzt werden, deren prinzipieller Aufbau dem Fachmann bekannt ist. Bei der Verwendung dieser geladenen organischen Moleküle in OLEDs ist es gegebenenfalls empfehlenswert, die kleinen Gegenionen durch größere, gleichermaßen geladene Gegenionen, wie $(PF_6)^-$, $(BF_4)^-$, $[CF_3SO_2]^-$, einfach negativ geladenes Hexa-phenylphosphat, einfach negativ geladenes Tetraphenyborat usw. zu ersetzen.

Einige Beispiel-Moleküle sind scheinbar symmetrisch aufgebaut und enthalten deswegen scheinbar keine getrennten D- bzw. A-Gruppen. Diese Moleküle werden aber in Lösung und/oder durch Einwirkung der Gegenionen derart polarisiert, dass entsprechende Donator- bzw. Akzeptor-Wirkungen resultieren.

**Patentansprüche**

**1.** Zusammensetzung, aufweisend

- ein organisches Molekül zur Emission von Licht, das einen $\Delta E(S_1\text{-}T_1)$-Wert zwischen dem untersten angeregten Singulett- ($S_1$) und dem darunter liegenden Triplett-Zustand ($T_1$) von kleiner als 2500 $cm^{-1}$ aufweist, wobei das organische Molekül kein Metallatom oder Metallion aufweist und
- ein optisch inertes Atom oder ein optisch inertes Molekül zur Reduktion der Inter-System-Crossing Zeitkonstante des organischen Moleküls auf kleiner als $10^{-6}$ s.

**2.** Die Zusammensetzung nach Anspruch 1, wobei das optisch inerte Atom oder Molekül oder Teile des optisch inerten Moleküls eine Spin-Bahn-Kopplungs-Konstante von größer 1000 $cm^{-1}$, bevorzugt von größer 3000 $cm^{-1}$, besonders bevorzugt von größer 4000 $cm^{-1}$ aufweist.

**3.** Die Zusammensetzung nach Anspruch 1 oder 2, wobei das organische Molekül in der Zusammensetzung einen $\Delta E(S_1\text{-}T_1)$-Wert zwischen dem untersten angeregten Singulett- und dem darunter liegenden Triplett-Zustand von kleiner als 1500 $cm^{-1}$, bevorzugt von kleiner als 1000 $cm^{-1}$ ausweist.

**4.** Zusammensetzung nach Anspruch 1 bis 3, wobei das organische Molekül aufweist:

- mindestens eine konjugierte organische Gruppe, die ausgewählt ist aus der Gruppe bestehend aus aromatischen, heteroaromatischen und konjugierten Doppelbindungen,
und

- mindestens eine chemisch gebundene Donatorgruppe mit elektronenschiebender Wirkung, und
- mindestens eine chemisch gebundene Akzeptorgruppe mit elektronenziehender Wirkung.

**5.** Zusammensetzung nach Anspruch 1 bis 4, wobei das organische Molekül ein Molekül der Formel I oder Formel II oder III ist.

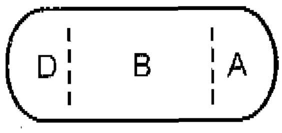

Formel I

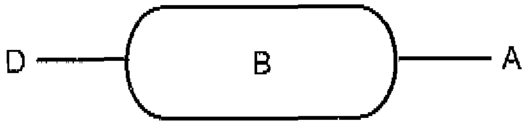

Formel II

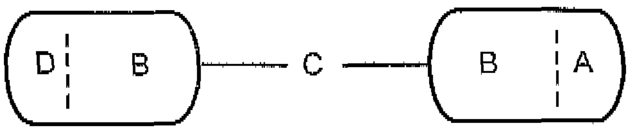

Formel III

wobei bedeutet:

D: eine chemische Gruppe oder ein Substituent mit elektronen-schiebender Eigenschaft der/die einfach, zweifach oder mehrfach vorhanden sein kann und gleich oder verschieden sein können;
A: eine chemische Gruppe oder ein Substituent mit elektronen-ziehender Eigenschaft, die/der einfach, zweifach oder mehrfach vorhanden sein kann und gleich oder verschieden sein können;
B: Grundgerüst, das aus konjugierten organischen Gruppen aufgebaut ist, die aus aromatischen, heteroaromatischen und/oder konjugierten Doppelbindungen bestehen;
C: eine die Grundgerüste B verknüpfende Gruppe, bevorzugt eine chemisch gebundene Alkenyl-Gruppen mit einer Anzahl von konjugierten Doppelbindungen kleiner 10.

**6.** Zusammensetzung nach Anspruch 1 bis 5, wobei das optisch inerte Atom oder Molekül im Emissionsbereich und/oder im HOMO-/LUMO-Bereich des organischen Moleküls keine Absorptionen oder Emissionen aufweist.

**7.** Zusammensetzung nach Anspruch 1 bis 6, wobei das optisch inerte Atom oder Molekül ausgewählt ist aus der Gruppe bestehend aus: Krypton- und Xenon-Edelgasen, Brom-aufweisenden Substanzen, Jod-aufweisenden Substanzen, Metallatomen, Metall-Nanoteilchen, Metallionen

und Gd-Komplexen.

8. Zusammensetzung nach Anspruch 1 bis 7, wobei das numerische Verhältnis zwischen organischen Molekülen und optisch inerten Atomen oder Molekülen 1 : 0,1 bis 1 : 10 beträgt.

9. Zusammensetzung nach Anspruch 1 bis 8, wobei das organische Molekül bei T = 300 K eine Emissionsabklingzeit von unter 5 μs, bevorzugt von unter 1,5 μs, besonders bevorzugt unter 1 μs und ganz besonders bevorzugt unter 500 ns aufweist.

10. Zusammensetzung nach Anspruch 1 bis 9, die eine bei T = 300 K gemessenen Emissionsquantenausbeute von mindestens 30 %, bevorzugt von mindestens 70 % und besonders bevorzugt von über 90 % aufweist.

11. Verwendung einer Zusammensetzung nach Anspruch 1 bis 10 in einer Emitterschicht in einer optoelektronischen Vorrichtung.

12. Verfahren zur Herstellung einer optoelektronischen Vorrichtung, wobei eine Zusammensetzung nach Anspruch 1 bis 10 verwendet wird.

13. Verfahren nach Anspruch 12, wobei Krypton oder Xenon als inertes Atom in Form eines Gases unter Normaldruck bis 300 kPa verwendet wird.

14. Optoelektronische Vorrichtung, aufweisend eine Zusammensetzung nach den Ansprüchen 1 bis 10.

15. Optoelektronische Vorrichtung nach Anspruch 14,
wobei der Anteil der Zusammensetzug in einer Emitterschicht 2 bis 100 Gew.-%, bevorzugt 6 bis 30 Gew.-%, bezogen auf das Gesamtgewicht der Emitterschicht, beträgt.

16. Organisch-elektronische Vorrichtung nach Anspruch 14 oder 15 in Form einer organischen Leuchtidiode (OLED), **gekennzeichnet durch** eine Zusammensetzung nach Anspruch 1 bis 11 aufweisende Emitterschicht, wobei der Anteil der Zusammensetzung in der Emitterschicht zwischen 2 bis 100 Gew.-%, bevorzugt 6 bis 30 Gew.-%, bezogen auf das Gesamtgewicht der Emitterschicht, beträgt.

17. Verfahren zur Verringerung der Emissionslebensdauer und zur Erhöhung der Elektrolumineszenz-Quantenaubeute unter Verwendung eines organischen Moleküls als Emitter in einer optoelektronischen Vorrichtung, wobei das organische Molekül kein Metallatom oder Metallion aufweist und einen $\Delta E(S_1\text{-}T_1)$-Wert zwischen dem untersten angeregten Singulett- und dem darunter liegenden Triplett-Zustand von kleiner als 2500 $cm^{-1}$ aufweist,
und wobei ein optisch inertes Atom oder Molekül zu dem organischen Molekül derart zugegeben wird, dass das optisch inerte Atom oder Molekül mit dem organischen Molekül in Wechselwirkung treten kann, wobei das optisch inerte Atom oder Molekül oder Teile des optisch inerten Moleküls eine Spin-Bahn-Kopplungs-Konstante von größer 1000 $cm^{-1}$, bevorzugt von größer 3000 $cm^{-1}$ besonders bevorzugt von größer 4000 $cm^{-1}$ aufweisen, so dass die Inter-System-Crossing Zeitkonstante des organischen Moleküls auf kleiner als $10^{-6}$ s verringert wird.

18. Verwendung nach Anspruch 11, Verfahren nach Anspruch 12, optoelektronische Vorrichtung nach Anspruch 14 oder 15, Verfahren nach Anspruch 17, wobei die optoelektronische Vorrichtung ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas- und Dampf-Sensoren, optischen Temperatur-Sensoren, organischen Solarzellen (OSCs), organischen Feldeffekttransistoren, organischen Lasern, organischen Dioden, organischen Photodioden und "down conversion" Systemen.

## Claims

1. A composition comprising

- an organic molecule for emission of light, said molecule having a $\Delta E(S_1\text{-}T_1)$ value between the lowermost excited singlet state ($S_1$) and the triplet state ($T_1$) below it of less than 2500 $cm^{-1}$, wherein the organic molecule does not comprise any metal atom or metal ion, and
- an optically inert atom or an optically inert molecule for reduction of the intersystem crossing time constant of

the organic molecule to less than $10^{-6}$ s.

**2.** The composition as claimed in claim 1, wherein the optically inert atom or molecule has, or parts of the optically inert molecule have, a spin-orbit coupling constant of greater than 1000 $cm^{-1}$, preferably of greater than 3000 $cm^{-1}$, more preferably of greater than 4000 $cm^{-1}$.

**3.** The composition as claimed in claim 1 or 2, wherein the organic molecule in the composition has a $\Delta E(S_1-T_1)$ value between the lowermost excited singlet state and the triplet state below it of less than 1500 $cm^{-1}$, preferably of less than 1000 $cm^{-1}$.

**4.** The composition as claimed in claims 1 to 3, wherein the organic molecule has:

- at least one conjugated organic group selected from the croup consisting of aromatic, heteroaromatic and conjugated double bonds, and
- at least one chemically bonded donor group having electron-donating auction, and
- at least one chemically bonded acceptor group having electron-withdrawing action.

**5.** The composition as claimed in claims 1 to 4, wherein the organic molecule is a molecule of the formula I or formula II or III

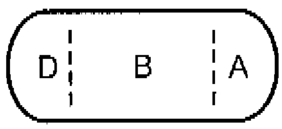

Formula I

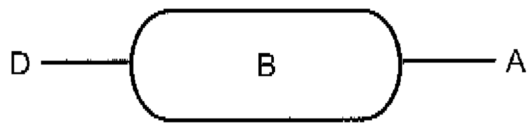

Formula II

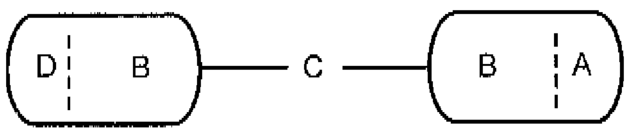

Formula III

wherein:

D: a chemical group or a substituent having electron-donating propensity which may be present once, twice or more than twice and may be the same or different;
A: a chemical group or a substituent with electron-withdrawing propensity which may be present once, twice or more than twice and may be the same or different;
B: base structure which is formed from conjugated organic groups which consist of aromatic, heteroaromatic and/or conjugated double bonds;
C: a group which links the base structures B, preferably a chemically bonded alkenyl group having a number of conjugated double bonds of less than 10.

**6.** The composition as claimed in claims 1 to 5, wherein the optically inert atom or molecule has no absorptions or emissions within the emission range and/or within the HOMO/LUMO range of the organic molecule.

**7.** The composition as claimed in claims 1 to 6, wherein the optically inert atom or molecule is selected from the group consisting of: krypton and xenon noble gases, bromine-containing substances, iodine-containing substances, metal atoms, metal nanoparticles, metal ions and gadolinium complexes.

**8.** The composition as claimed in claims 1 to 7, wherein the numerical ratio between organic molecules and optically inert atoms or molecules is 1:0.1 to 1:10.

**9.** The composition as claimed in claims 1 to 8, wherein the organic molecule at T = 300 K has an emission decay time of less than 5 µs, preferably of less than 1.5 µs, more preferably less than 1 µs and most preferably less than 500 ns.

**10.** The composition as claimed in claims 1 to 9, which has an emission quantum yield measured at T = 300 K of at least 30%, preferably of at least 70% and more preferably of more than 90%.

**11.** Use of a composition as claimed in claims 1 to 10 in an emitter layer in an optoelectronic device.

**12.** A process for producing an optoelectronic device, wherein a composition as claimed in claims 1 to 10 is used.

**13.** The process as claimed in claim 12, wherein krypton or xenon is used as the inert atom in the form of a gas under standard pressure up to 300 kPa.

**14.** An optoelectronic device comprising a composition as claimed in claims 1 to 10.

**15.** The optoelectronic device as claimed in claim 14, wherein the proportion of the composition in an emitter layer is 2 to 100% by weight, preferably 6 to 30% by weight, based on the total weight of the emitter layer.

**16.** The organic electronic device as claimed in claim 14 or 15 in the form of an organic light-emitting diode (OLED), **characterized by** an emitter layer comprising a composition as claimed in claims 1 to 11, the proportion of the composition in the emitter layer being between 2 and 100% by weight, preferably 6 to 30% by weight, based on the total weight of the emitter layer.

**17.** A process for reducing the emission lifetime and for increasing the electroluminescence quantum yield using an organic molecule as an emitter in an optoelectronic device, wherein the organic molecule does not comprise any metal atom or metal ion and has a $\Delta E(S_1-T_1)$ value between the lowermost excited singlet state and the triplet state below of less than 2500 $cm^{-1}$,
and wherein an optically inert atom or molecule is added to the organic molecule such that the optically inert atom or molecule can interact with the organic molecule, the optically inert atom or molecule or parts of the optically inert molecule having a spin-orbit coupling constant of greater than 1000 $cm^{-1}$, preferably of greater than 3000 $cm^{-1}$, more preferably of greater than 4000 $cm^{-1}$, such that the intersystem crossing time constant of the organic molecule is reduced to less than $10^{-6}$ s.

**18.** The use as claimed in claim 11, process as claimed in claim 12, optoelectronic device as claimed in claim 14 or 15, process as claimed in claim 17, wherein the optoelectronic device is selected from the group consisting of organic

light-emitting diodes (OLEDs), light-emitting electrochemical cells (LEECs or LECs), OLED sensors, especially gas and vapor sensors without hermetic shielding from the outside, optical temperature sensors, organic solar cells (OSCs), organic field-effect transistors, organic lasers, organic diodes, organic photodiodes and "down conversion" systems.

**Revendications**

**1.** Composition, comprenant :

- une molécule organique pour l'émission de lumière, qui présente une valeur $\Delta E(S_1\text{-}T_1)$ entre l'état singulet excité le plus bas ($S_1$) et l'état triplet sous-jacent ($T_1$) inférieure à 2 500 $cm^{-1}$, la molécule organique ne comprenant pas d'atome métallique ou d'ion métallique, et
- un atome optiquement inerte ou une molécule optiquement inerte pour la réduction de la constante temporelle de conversion intersystème de la molécule organique à moins $10^{-6}$ s.

**2.** Composition selon la revendication 1, dans laquelle l'atome ou la molécule optiquement inerte ou des parties de la molécule optiquement inerte présentent une constante de couplage spin-orbite supérieure à 1 000 $cm^{-1}$, de préférence supérieure à 3 000 $cm^{-1}$, de manière particulièrement préférée supérieure à 4 000 $cm^{-1}$.

**3.** Composition selon la revendication 1 ou 2, dans laquelle la molécule organique dans la composition présente une valeur $\Delta E(S_1\text{-}T_1)$ entre l'état singulet excité le plus bas et l'état triplet sous-jacent inférieure à 1 500 $cm^{-1}$, de préférence inférieure à 1 000 $cm^{-1}$.

**4.** Composition selon les revendications 1 à 3, dans laquelle la molécule organique comprend :

- au moins un groupe organique conjugué, qui est choisi dans le groupe constitué par les doubles liaisons aromatiques, hétéroaromatiques et conjuguées, et
- au moins un groupe donneur relié chimiquement à effet donneur d'électrons, et
- au moins un groupe accepteur relié chimiquement à effet attracteur d'électrons.

**5.** Composition selon les revendications 1 à 4, dans laquelle la molécule organique est une molécule de formule I ou de formule II ou III

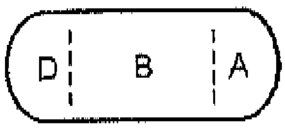

Formule I

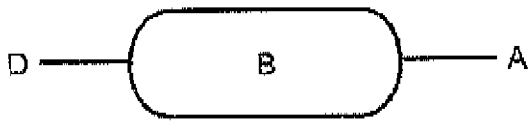

Formule II

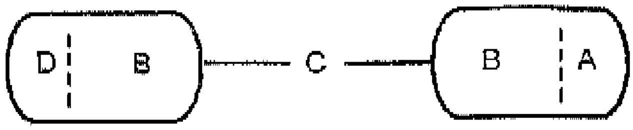

Formule III

dans lesquelles

D signifie: un groupe chimique ou un substituant à effet donneur d'électrons, qui peut être présent une fois, deux fois ou plus, de manière identique ou différente ;
A signifie : un groupe chimique ou un substituant à effet attracteur d'électrons, qui peut être présent une fois, deux fois ou plus, de manière identique ou différente ;
B signifie: un squelette de base, qui est formé par des groupes organique conjugués, qui sont constitués de doubles liaisons aromatiques, hétéroaromatiques et/ou conjuguées ;
C signifie : un groupe relié au squelette de base B, de préference un groupe alcényle relié chimiquement contenant un nombre de doubles liaisons conjuguées inférieur à 10.

**6.** Composition selon les revendications 1 à 5, dans laquelle l'atome ou la molécule optiquement inerte ne présente pas d'absorption ou d'émission dans la plage d'émission et/ou dans la plage HOMO/LUMO de la molécule organique.

**7.** Composition selon les revendications 1 à 6, dans laquelle l'atome ou la molécule optiquement inerte est choisi dans le groupe constitué par : les gaz nobles de krypton et de xénon, les substances comprenant du brome, les substances comprenant de l'iode, les atomes métalliques, les nanoparticules métalliques, les ions métalliques et les complexes de Gd.

**8.** Composition selon les revendications 1 à 7, dans laquelle le rapport numérique entre les molécules organique et les atomes ou molécules optiquement inertes est de 1:0,1 à 1:10.

**9.** Composition selon les revendications 1 à 8, dans laquelle la molécule organique présente à T = 300 K un temps de déclin d'émission inférieur à 5 µs, de préférence inférieur à 1,5 µs, de manière particulièrement préférée inférieur à 1 µs et de manière tout particulièrement préférée inférieur à 500 ns.

**10.** Composition selon les revendications 1 à 9, qui présente un rendement quantique d'émission mesuré à T = 300 K d'au moins 30 %, de préférence d'au moins 70 % et de manière particulièrement préférée de plus de 90 %.

**11.** Utilisation d'une composition selon les revendications 1 à 10 dans une couche d'émission d'un dispositif optoélectronique.

**12.** Procédé de fabrication d'un dispositif optoélectronique, dans lequel une composition selon les revendications 1 à 10 est utilisée.

**13.** Procédé selon la revendication 12, dans lequel du krypton ou du xénon est utilisé en tant qu'atome inerte sous la forme d'un gaz à une pression normale de jusqu'à 300 kPa.

**14.** Dispositif optoélectronique, comprenant une composition selon les revendications 1 à 10.

**15.** Dispositif optoélectronique selon la revendication 14, dans lequel la proportion de la composition dans une couche d'émission est de 2 à 100 % en poids, de préférence de 6 à 30 % en poids, par rapport au poids total de la couche d'émission.

**16.** Dispositif électronique organique selon la revendication 14 ou 15 sous la forme d'une diode organique électroluminescente (OLED), **caractérisé par** une couche d'émission comprenant une composition selon les revendications 1 à 11, la proportion de la composition dans la couche d'émission étant comprise entre 2 et 100 % en poids, de préférence 6 et 30 % en poids, par rapport au poids total de la couche d'émission.

**17.** Procédé de réduction de la durée de vie d'émission et d'augmentation du rendement quantique d'électroluminescence, utilisant une molécule organique en tant qu'émetteur dans un dispositif optoélectronique, la molécule organique ne comprenant pas d'atome métallique ou d'ion métallique et présentant une valeur $\Delta E(S_1-T_1)$ entre l'état singulet excité le plus bas et l'état triplet sous-jacent inférieure à 2 500 $cm^{-1}$, et un atome ou une molécule optiquement inerte étant ajouté à la molécule organique, de sorte que l'atome ou la molécule optiquement inerte puisse interagir avec la molécule organique, l'atome ou la molécule optiquement inerte ou des parties de la molécule optiquement inerte présentant une constante de couplage spin-orbite supérieure à 1 000 $cm^{-1}$, de préférence supérieure à 3 000 $cm^{-1}$, de manière particulièrement préférée supérieure à 4 000 $cm^{-1}$, de sorte que la constante temporelle de conversion intersystème de la molécule organique soit réduite à moins de $10^{-6}$ s.

**18.** Utilisation selon la revendication 11, procédé selon la revendication 12, dispositif optoélectronique selon la revendication 14 ou 15, procédé selon la revendication 17, dans lesquels le dispositif optoélectronique est choisi dans le groupe constitué par les diodes électroluminescentes (OLED), les cellules électrochimiques émettrices de lumière (LEEC ou LEC), les capteurs OLED, notamment les capteurs de gaz et de vapeur non blindés hermétiquement vers l'extérieur, les capteurs de température optiques, les cellules solaires organiques (CSO), les transistors à effet de champ organiques, les lasers organiques, les diodes organiques, les photodiodes organiques et les systèmes convertisseurs-abaisseurs.

Figur 1

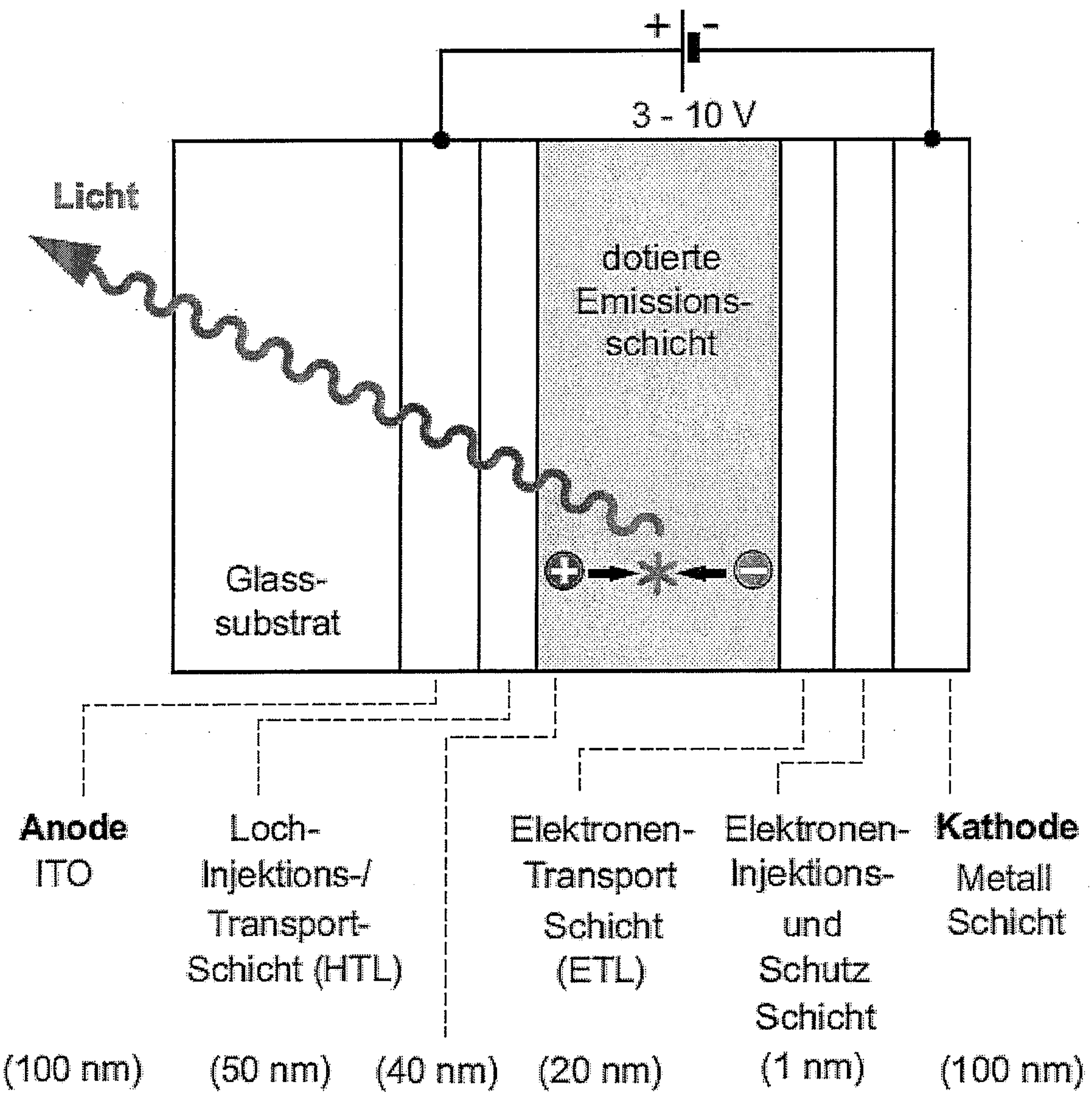
+
-
3 - 10 V
Licht
dotierte Emissions-schicht
Glass-substrat
Anode ITO (100 nm)
Loch-Injektions-/Transport-Schicht (HTL) (50 nm)
(40 nm)
Elektronen-Transport Schicht (ETL) (20 nm)
Elektronen-Injektions- und Schutz Schicht (1 nm)
Kathode Metall Schicht (100 nm)

Figur 2

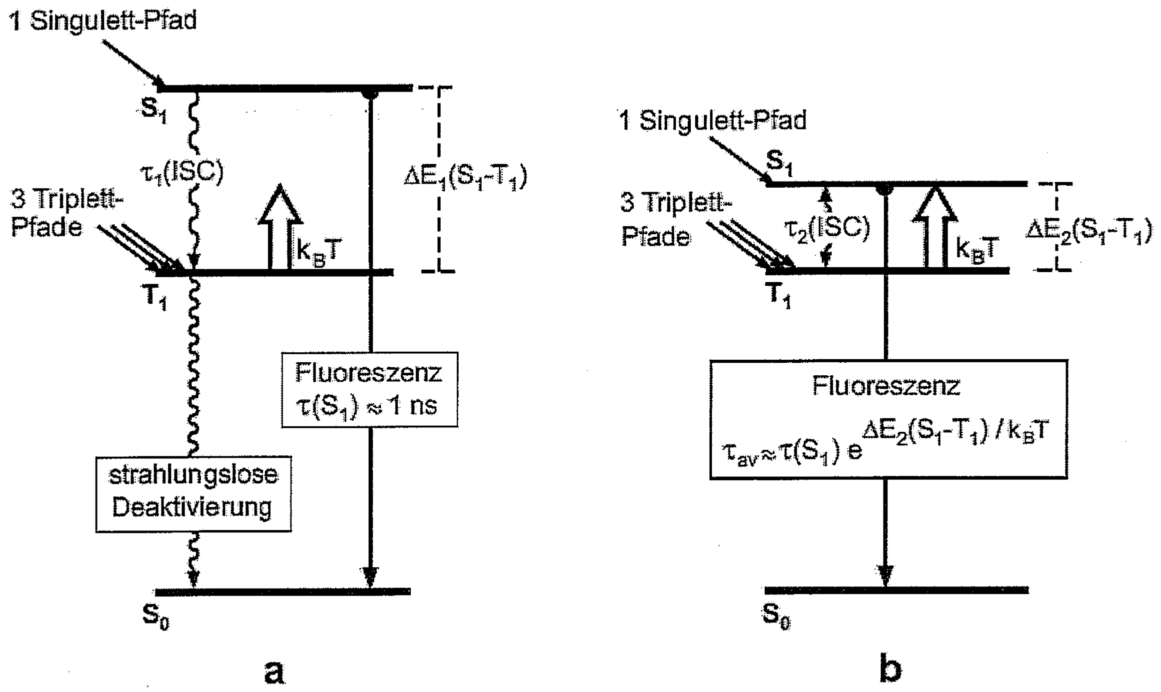
1 Singulett-Pfad
$S_1$
$\tau_1$(ISC)
3 Triplett-Pfade
$\Delta E_1(S_1-T_1)$
$k_BT$
$T_1$
Fluoreszenz
$\tau(S_1) \approx 1$ ns
strahlungslose Deaktivierung
$S_0$
a
1 Singulett-Pfad
$S_1$
3 Triplett-Pfade
$\tau_2$(ISC)
$k_BT$
$\Delta E_2(S_1-T_1)$
$T_1$
Fluoreszenz
$\tau_{av} \approx \tau(S_1)\, e^{\Delta E_2(S_1-T_1)/k_BT}$
$S_0$
b

Figur 3A

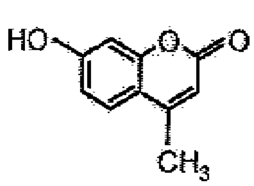

Cumarin 4

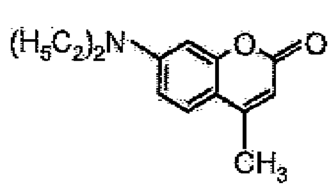

Cumarin 47

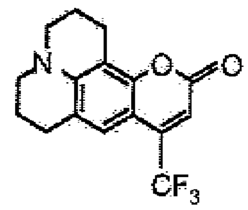

Cumarin 153

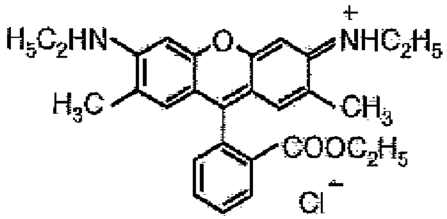

Rhodamin 6G

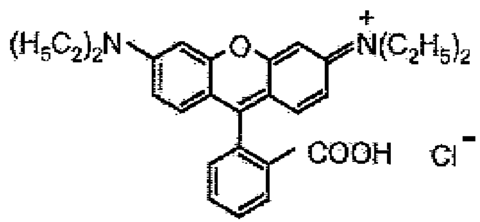

Rhodamin B

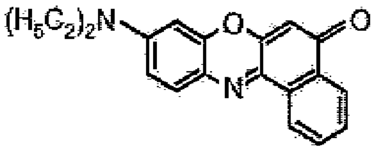

Phenoxazon 9

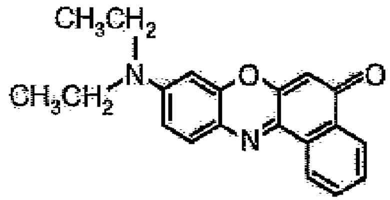

Nilrot

Figur 3A

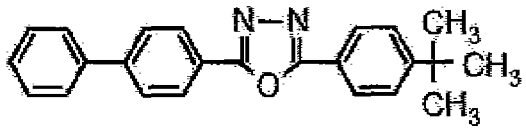

2-(4-Biphenylyl)-5-(4-t-butylphenyl)-1,3,4-oxadiazol

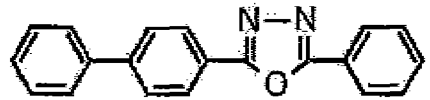

2-(4-Biphenylyl)-5-phenyl-1,3,4-oxadiazol

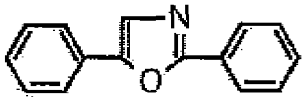

2,5-Diphenyloxazol

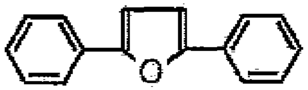

2,5-Diphenylfuran

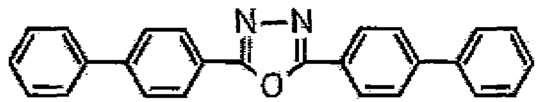

2,5-Bis-(4-biphenylyl)-1,3,4-oxadiazol

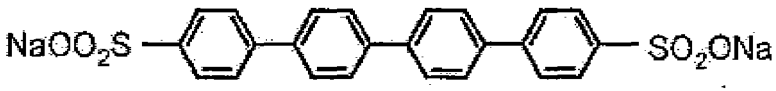

p-Quaterphenyl-4,4'''-disulfonsäure Dinatrium

Figur 3B

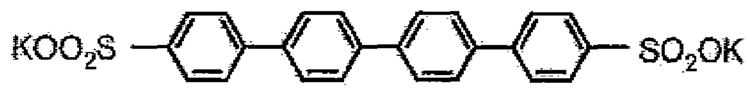

p-Quaterphenyl-4,4'''-disulfonsäure Diphosphat

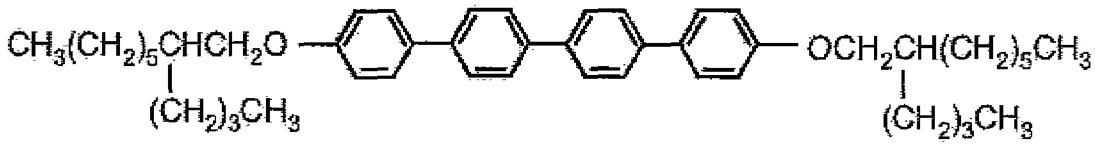

4,4'''-Bis-(2-butyloctyloxy)-p-quaterphenyl

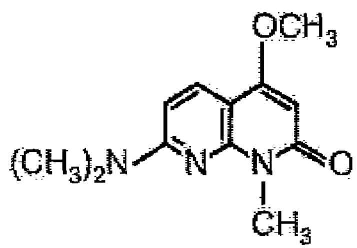

7-Dimethylamino-1-methyl-4-methoxy-8-azaquinoion-2

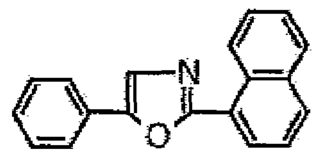

2-(1-Naphthyl)-5-phenyloxazol

Figur 3B

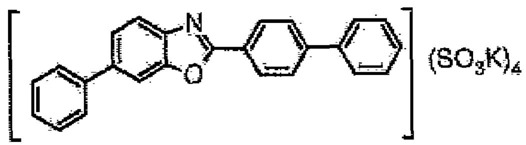

Furan 2

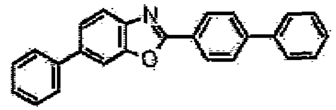

2-(4-Biphenylyl)-5-phenylbenzoxazol-1,3

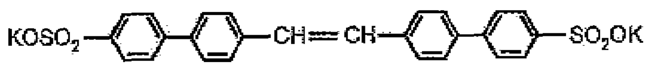

Stilben 1

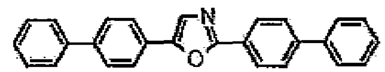

2,5-Bis-(4-biphenylyl)-oxazol

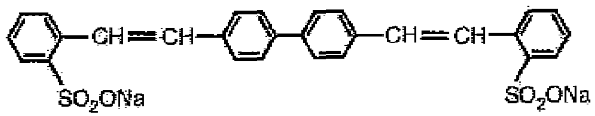

Stilben 3

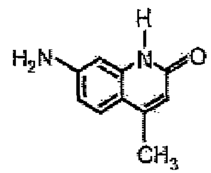

Carbostyryl 7

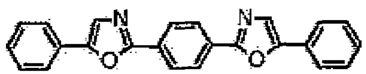

1,4-Di[2-(5-phenyloxazolyl) ] benzol

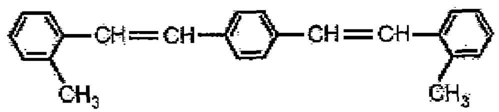

P-Bis(o-methylstyryl)-benzol

Figur 3C

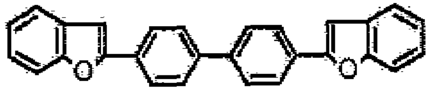

Furan 1

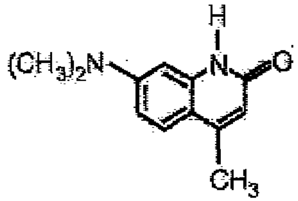

Carbostyryl 3

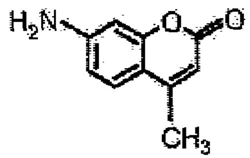

Cumarin 120

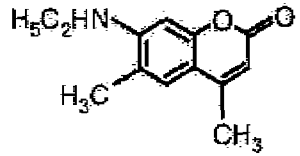

Cumarin 2

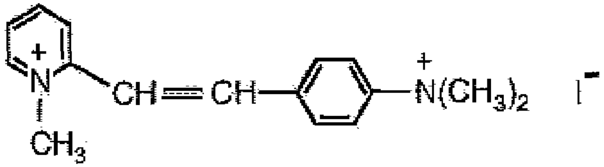

2-(p-Dimethylaminostyryl)-pyridylmethyl Iodid

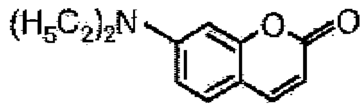

Cumarin 466

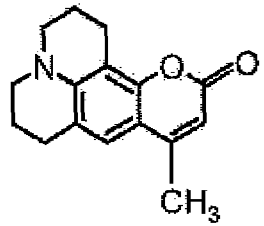

Cumarin 102

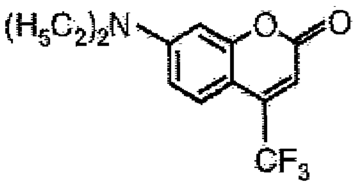

Cumarin 152A

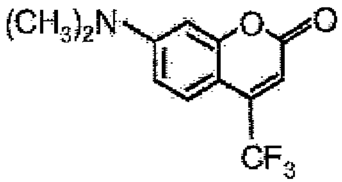

Cumarin 152

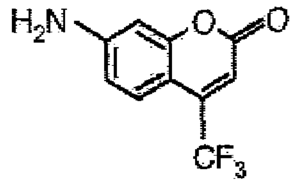

Cumarin 151

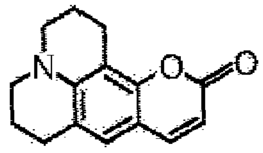

Cumarin 6H

Figur 3C

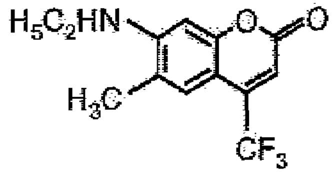

Cumarin 307

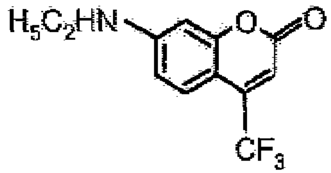

Cumarin 500

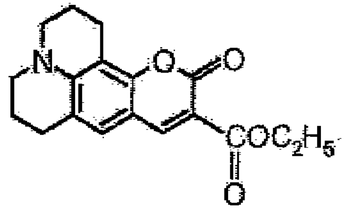

Cumarin 314

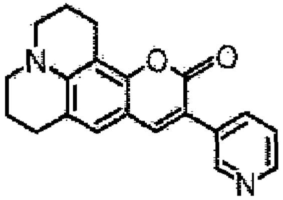

Cumarin 510

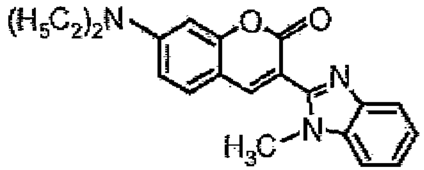

Cumarin 30

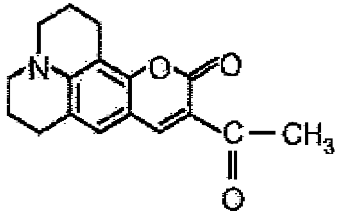

Cumarin 334

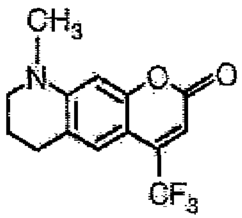

Cumarin 522

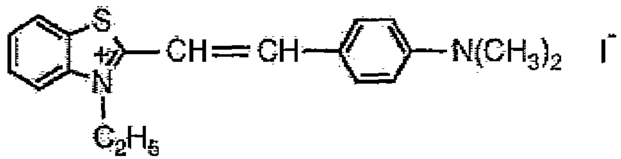

2-(p-Dimethylaminostyryl)-benzothiazolylethyl Iodid

Figur 3D

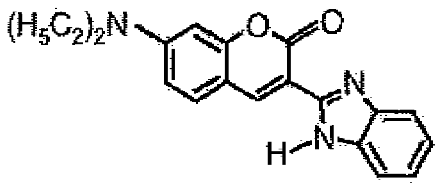

Cumarin 7

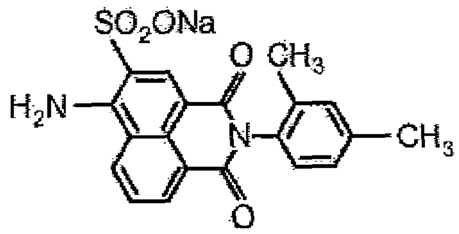

Brillantsulfaflavin

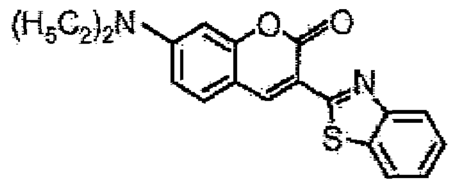

Cumarin 6

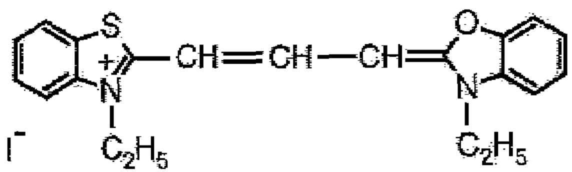

3,3'-Diethyloxacarbocyanin Iodid

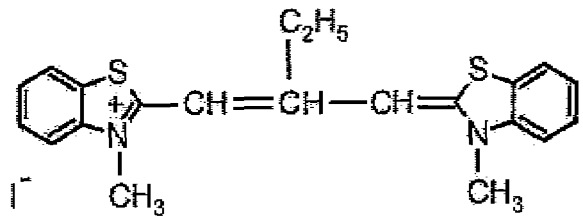

3,3'-Dimethyl-9-ethylthiacarbocyanin Iodid

Figur 3D

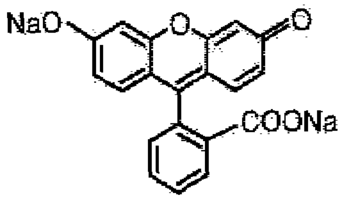

Uranin

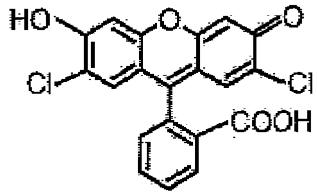

Fluorescein 27

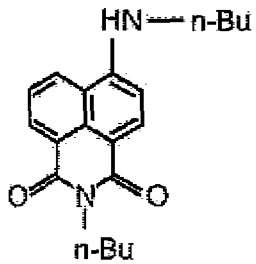

Fluorol 7GA

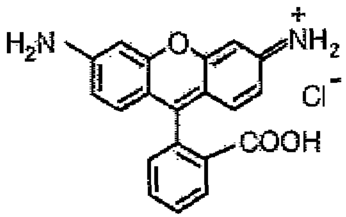

Rhodamin 110

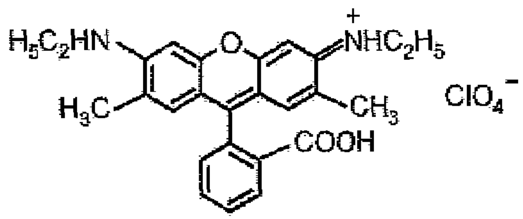

Rhodamin 19

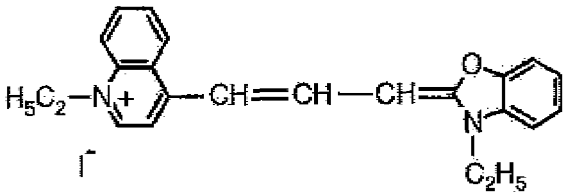

DQOCI

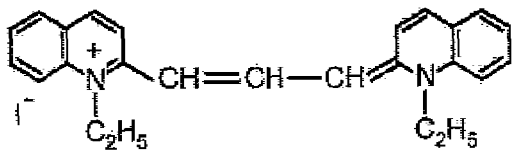

DCI-2

Figur 3E

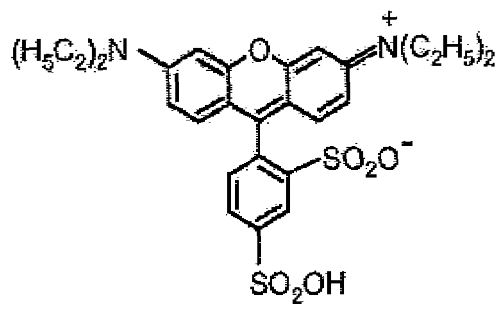

Sulforhodamin B

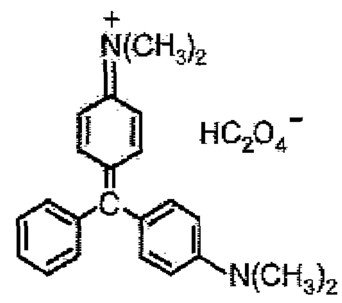

Malachitgrün

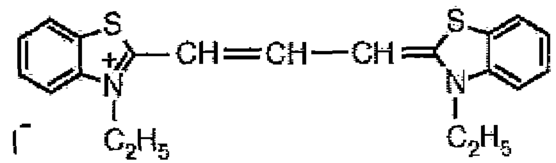

3,3'-Diethylthiacarbocyanin Iodid

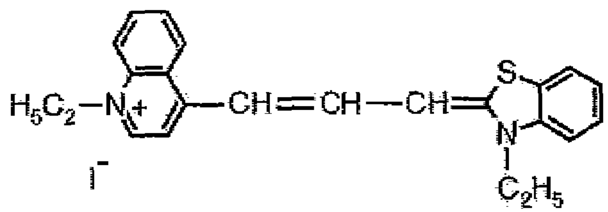

1,3'-Diethyl-4,2'-quinolylthiacarbocyanin Iodid

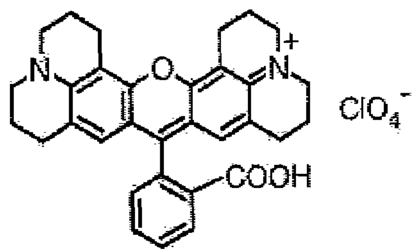

Rhodamin 101

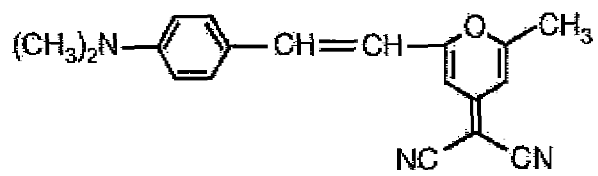

DCM

Figur 3E

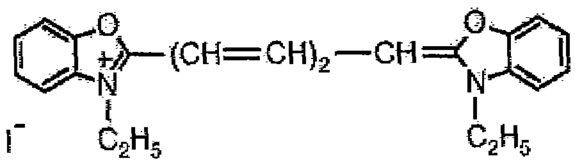

3,3'-Diethyloxadicarbocyanin Iodid

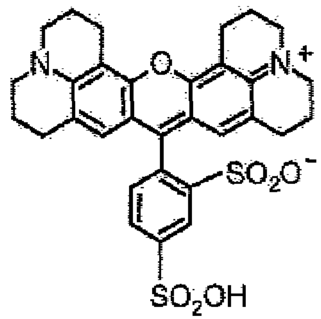

Sulforhodamin 101

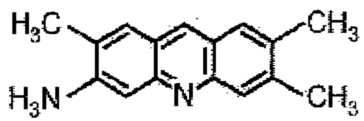

Acridin und weitere Acridin-Derivate

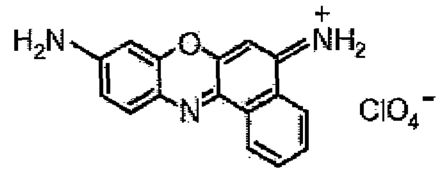

Cresylviolett

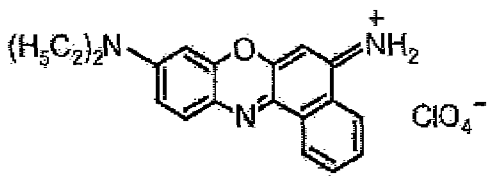

Nilblau

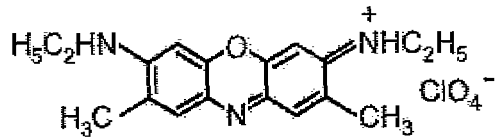

Oxazin 4

Figur 3F

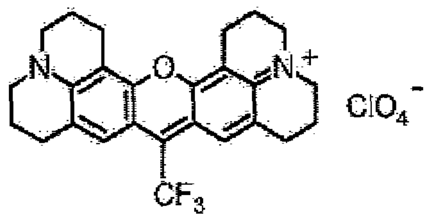

Rhodamin 700

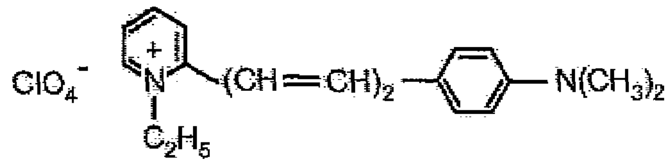

Pyridin 1

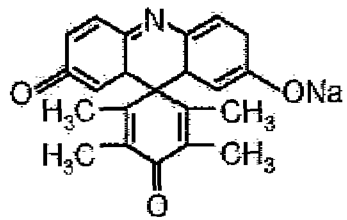

Carbazin 122

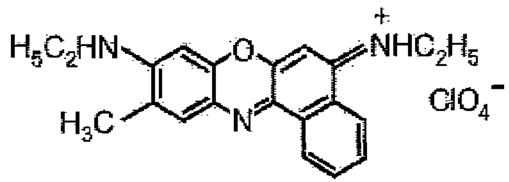

Oxazin 170

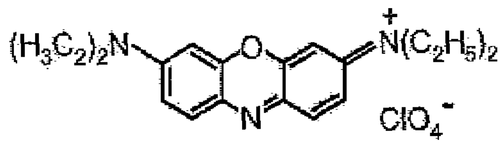

Oxazin 1

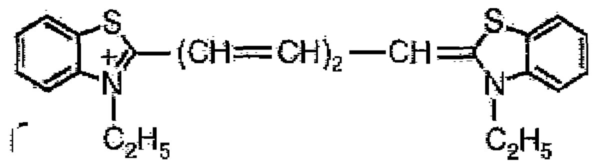

3-Diethylthiadicarbocyanin Iodid

Figur 3F

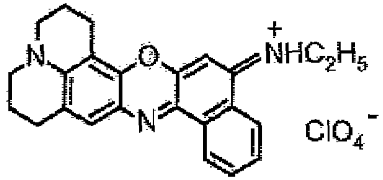

Oxazin 750

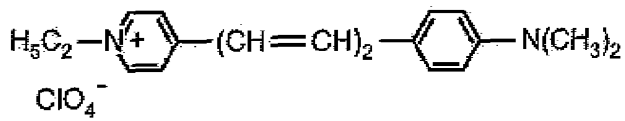

Pyridin 2

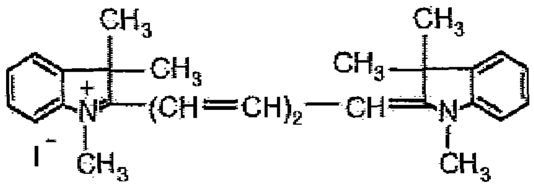

1,1',3,3,3',3'-Hexamethylindo-dicarbocyanin Iodid

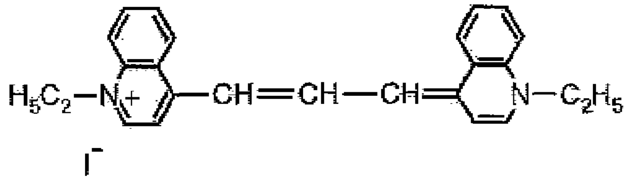

Cryptocyanin

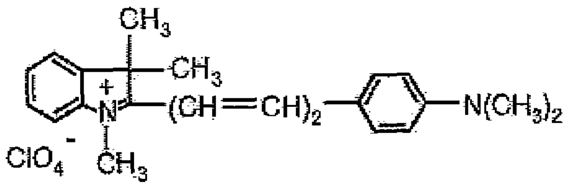

Styryl 6

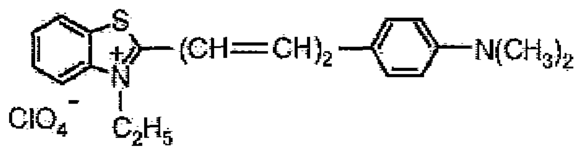

Styryl 8

Figur 3G

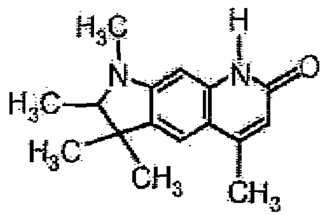

1,2,3,8-tetrahydro-1,2,3,5-pentamethyl-7H-pyrrolo[3,2-g]quinolin-7-on

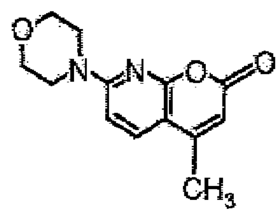

4-methyl-7-(4-morpholinyl)-2H-pyrano[2,3-b]pyridin-2-on

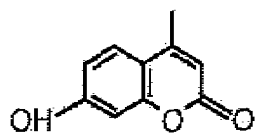

7-Hydroxy-4-methylcumarin

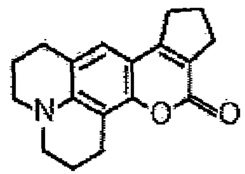

2,3,6,7,10,11-hexahydro-1H,5H-cyclopental [3,4][1]benzopyrano[6,7,8-ij]quinolizin-12(9H)-on

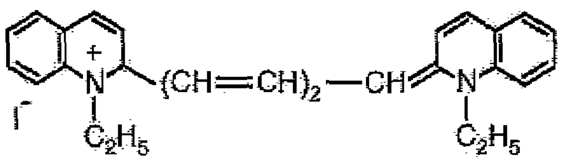

1,1'-Diethyl-2,2'-dicarbocyanin lodid

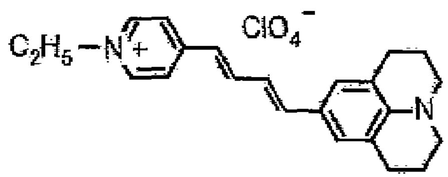

Pyridin 4

Figur 3G

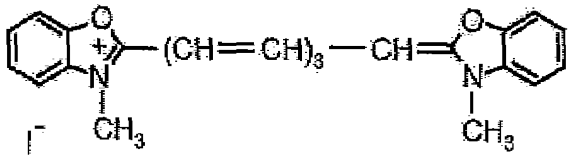

Methyl-DOTCI

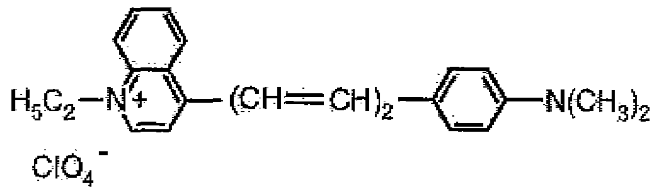

Styryl 11

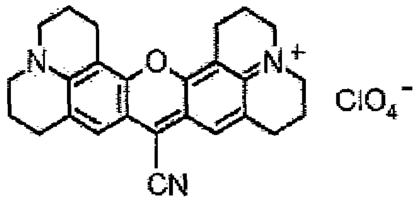

Rhodamin 800

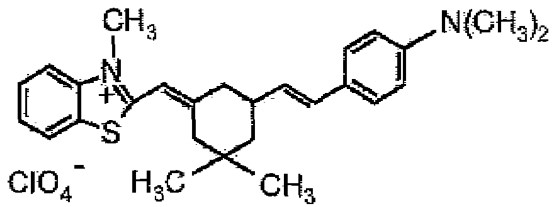

Styryl 9M

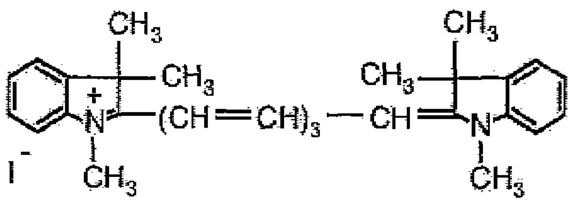

1,1',3,3,3',3'-Hexamethylindotricarbo-cyanin Iodid Hexacyanin 3

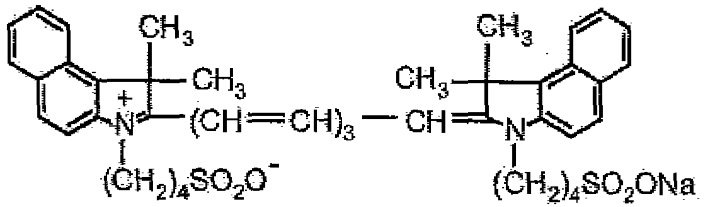

IR 125 - $C_{43}H_{47}N_2O_6S_2Na$

Figur 3H

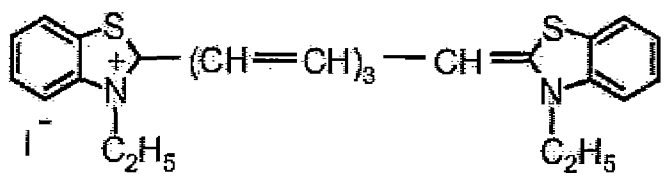

3,3'-Diethylthiatricarbocyanin Iodid

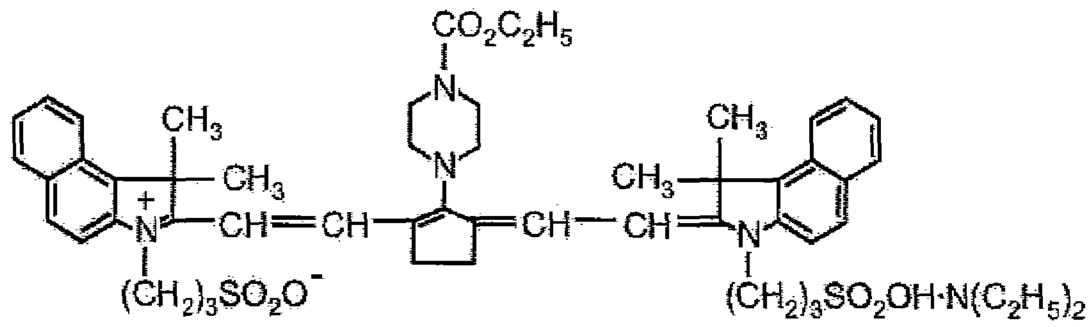

IR 144 - $C_{56}H_{73}N_5O_8S_2$

Figur 3H

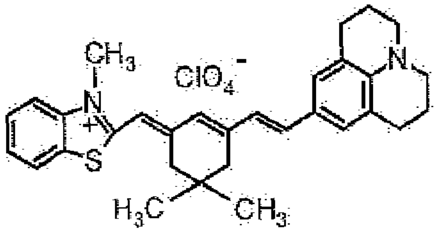

Styryl 15

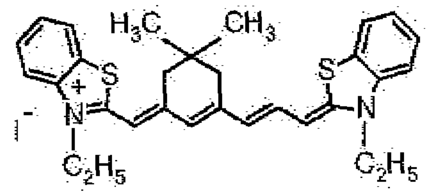

3,3'-Diethyl-9,11-neopentylenthiatricarbocyanin Iodid

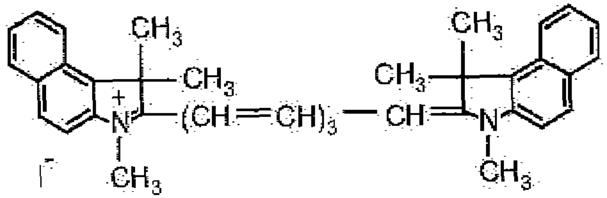

HDITCI

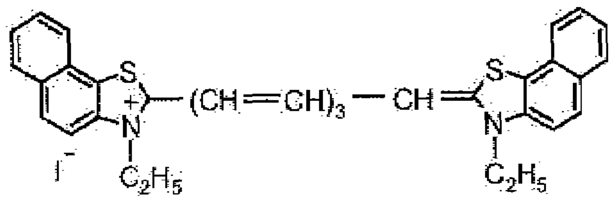

DDTTCI

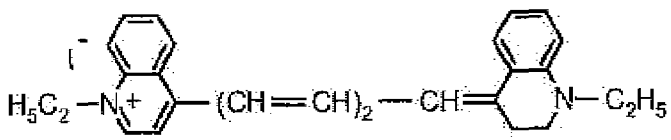

1,2'-Diethyl-4,4'-dicarbocyanin Iodid

Figur 3I

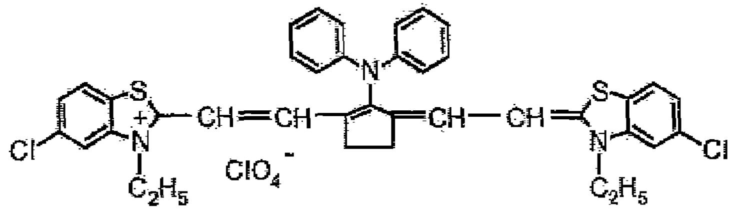

IR 140 – $C_{39}H_{34}N_3O_4S_2Cl$

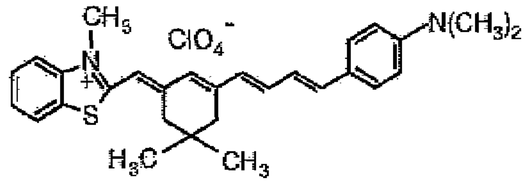

Styryl 14

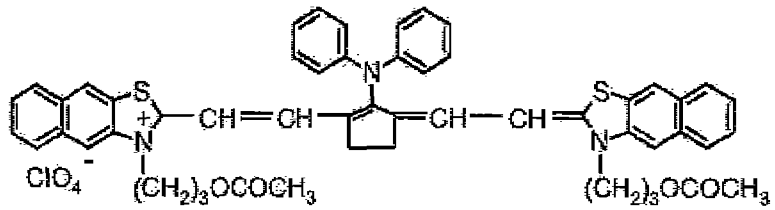

IR 132 – $C_{59}H_{48}N_3O_8S_2Cl$

Figur 3l

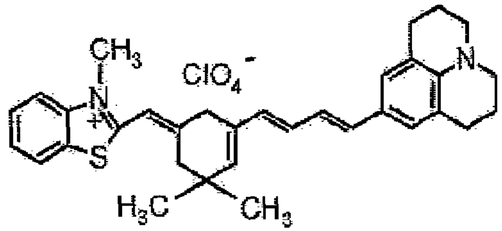

Styryl 20

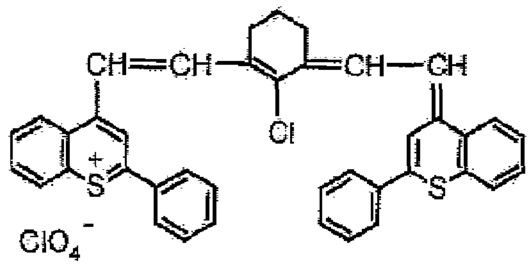

IR 26 – $C_{40}H_{30}O_4S_2Cl$

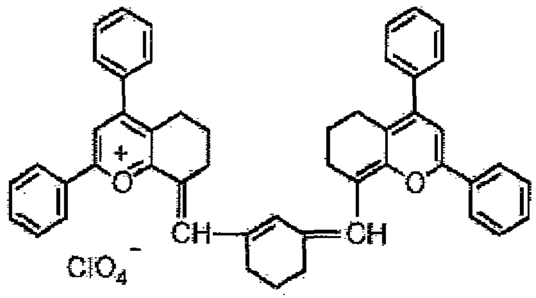

IR 5 – $C_{50}H_{43}O_6Cl$

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102008033563 A1
- US 20020008233 A1
- US 7416791 B1
- WO 2011089163 A1


### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **TANG et al.** *Appl. Phys. Lett.,* 1987, vol. 51, 913
- **M. A. BALDO ; D. F. O'BRIEN ; M. E. THOMPSON ; S. R. FORREST.** *Phys. Rev. B,* 1999, vol. 60, 14422
- **S. R. FORREST et al.** *Phys. Rev. B,* 2008, vol. 77, 235215
- **J. KIDO et al.** *Jap. J. Appl. Phys.,* 2007, vol. 46, L10